# EUROPEAN PATENT APPLICATION

(11) **EP 4 514 102 A1**
(43) Date of publication of application: **26.02.2025**
(21) Application number: 24196025.1
(22) Date of filing: 22.08.2024
(51) Int. Cl.: H10K 50/824, H10K 50/844, H10K 59/122, H10K 59/88, H10K 59/80

(54) **DISPLAY PANEL AND METHOD FOR MANUFACTURING THE SAME**

(30) Priority: 25.08.2023 KR 20230112149
(71) Applicant: Samsung Display Co., Ltd., Gyeonggi-do (KR)
(72) Inventor: PARK, Jonghee, Yongin-si (KR); KIM, Hyoung Sik, Yongin-si (KR); PARK, Ilwoo, Yongin-si (KR)
(74) Representative: Marks & Clerk LLP

(57) **Abstract**

A display panel includes: a base layer; a first electrode disposed on the base layer; a pixel-defining film in which a light-emitting opening partially exposing the first electrode is defined, and which is disposed on the base layer; a first conductive partition wall in which a first partition wall opening overlapping the light-emitting opening in a plan view is defined, and which is disposed on the pixel-defining film; a second conductive partition wall in which a second partition wall opening overlapping the first partition wall opening, and a dummy opening overlapping the first conductive partition wall in the plan view are defined, and which is disposed on the first conductive partition wall; a second electrode disposed on the first electrode, and a light-emitting pattern disposed between the first electrode and the second electrode.

## Description

### BACKGROUND

The present disclosure herein relates to a display panel and a method for manufacturing the same, and more particularly, to a display panel with improved processability and reliability and a method for manufacturing the same.

Multimedia electronic devices such as televisions, mobile phones, tablet computers, computers, navigation systems, and game consoles are provided with a display panel for displaying an image.

The display panel includes a light-emitting element and a pixel circuit for driving the light-emitting element. The light-emitting element included in the display panel emits light and generates the image according to a voltage applied by the pixel circuit.

Research on a method for patterning the light-emitting element is being conducted so as to improve reliability of the display panel, and recently, research on a method for pattering, as a pixel unit, a light-emitting material commonly supplied using an open mask is also on going.

### SUMMARY

The present disclosure provides a display panel with improved reliability.

The present disclosure also provides a method for manufacturing a display panel with improved processability and reliability.

An embodiment of the invention provides a display panel including: a base layer; a first electrode disposed on the base layer; a pixel-defining film in which a light-emitting opening partially exposing the first electrode is defined, and which is disposed on the base layer; a first conductive partition wall in which a first partition wall opening overlapping the light-emitting opening in a plan view is defined, and which is disposed on the pixel-defining film; a second conductive partition wall in which a second partition wall opening overlapping the first partition wall opening, and a dummy opening overlapping the first conductive partition wall in the plan view are defined, and which is disposed on the first conductive partition wall; a second electrode disposed on the first electrode; and a light-emitting pattern disposed between the first electrode and the second electrode.

In an embodiment, the display panel may further include an inorganic lower encapsulation pattern disposed on the second electrode, and covering the light-emitting opening, the first partition wall opening, and the second partition wall opening.

In an embodiment, the display panel may further include an inorganic intermediate encapsulation film covering the dummy opening and an upper surface of the second conductive partition wall.

In an embodiment, an upper surface of the first conductive partition wall exposed by the dummy opening may be in contact with the inorganic intermediate encapsulation film.

In an embodiment, a side surface defining the second partition wall opening of the second conductive partition wall may be in contact with the inorganic lower encapsulation pattern, and a side surface defining the dummy opening of the second conductive partition wall may be in contact with the inorganic intermediate encapsulation film.

In an embodiment, the dummy opening may be provided in plurality.

In an embodiment, the first conductive partition wall may include a first lower layer disposed on the pixel-defining film and a second lower layer disposed on the first lower layer, and a side surface of the second lower layer may protrude further than a side surface of the first lower layer in the plan view.

In an embodiment, the second conductive partition wall may include a first upper layer disposed on the first conductive partition wall and a second upper layer disposed on the first upper layer, and a side surface of the second upper layer may protrude further than a side surface of the first upper layer in the plan view.

In an embodiment, the second electrode may be in contact with a side surface of the first conductive partition wall to be electrically connected to each other.

In an embodiment, a bias voltage may be applied to the first conductive partition wall.

In an embodiment, the display panel may further include an inorganic dummy encapsulation film covering the dummy opening.

In an embodiment, the display panel may further include a dummy pattern disposed on the first conductive partition wall in the dummy opening.

In an embodiment, the dummy pattern may not be in contact with the second conductive partition wall.

In an embodiment, a side surface defining the second partition wall opening of the second conductive partition wall may be in contact with the inorganic lower encapsulation pattern, and a side surface defining the dummy opening of the second conductive partition wall may be in contact with the inorganic dummy encapsulation film.

In an embodiment of the invention, a method for manufacturing a display panel includes: preparing a preliminary display panel including a base layer, a first conductive electrode disposed on the base layer, a preliminary pixel-defining film covering the first electrode and disposed on the base layer, a first conductive layer disposed on the preliminary pixel-defining film, and a second conductive layer disposed on the first conductive layer; patterning photoresist on the preliminary display panel; forming a second preliminary partition wall opening in the second conductive layer; forming a first preliminary conductive partition wall by forming, in the first conductive layer, a first preliminary partition wall opening overlapping the second preliminary partition wall opening in a plan view; forming a second preliminary conductive partition wall by forming, in the second conductive layer, a preliminary dummy opening spaced apart from the second partition wall opening; forming a light-emitting pattern on the first electrode; and forming a second electrode on the light-emitting pattern, where in the patterning of the photoresist, the photoresist is patterned to have a first thickness in a first region overlapping neither the second preliminary partition wall opening nor the preliminary dummy opening in the plan view, the photoresist is patterned to have a second thickness smaller than the first thickness in a second region overlapping the preliminary dummy opening in the plan view, and the photoresist is patterned not to be disposed in a third region overlapping the second preliminary partition wall opening in the plan view.

In an embodiment, the forming of the second preliminary partition wall opening may include forming by dry-etching the second conductive layer corresponding to the third region, the forming of the second preliminary conductive partition wall may include removing the photoresist corresponding to the second region by ashing the photoresist, and dry-etching the second conductive layer corresponding to the second region, and the forming of the first preliminary conductive partition wall may include dry-etching the first conductive layer corresponding to the third region.

In an embodiment, the method may further include forming a first conductive partition wall defining a first partition wall opening and a second conductive partition wall defining a second partition wall opening by wet-etching side surfaces of the first preliminary conductive partition wall and the second preliminary conductive partition wall, where the first preliminary conductive partition wall may include a first preliminary lower layer disposed on the preliminary pixel-defining film and a second preliminary lower layer disposed on the first preliminary lower layer, the second preliminary conductive partition wall may include a first preliminary upper layer and a second preliminary upper layer disposed on the first preliminary upper layer, an etch rate of the first preliminary lower layer may be greater than an etch rate of the second preliminary lower layer, and an etch rate of the first preliminary upper layer may be greater than an etch rate of the second preliminary upper layer.

In an embodiment, the method may further include forming a pixel-defining film in which a light-emitting opening is defined by dry-etching the preliminary pixel-defining film corresponding to the first partition wall opening.

In an embodiment, the method may further include forming, on the second electrode, an inorganic lower encapsulation pattern covering the light-emitting opening, the first partition wall opening, and the second partition wall opening.

In an embodiment, the method may further include forming an inorganic intermediate encapsulation film covering the dummy opening and an upper surface of the second conductive partition wall.

At least some of the above and other features of the invention are set out in the claims.

### BRIEF DESCRIPTION OF THE FIGURES

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1A is a combined perspective view of a display device according to an embodiment of the invention;
FIG. 1B is an exploded perspective view of a display device according to an embodiment of the invention;
FIG. 2 is a cross-sectional view of a display module according to an embodiment of the invention;
FIG. 3 is a plan view of a display panel according to an embodiment of the invention;
FIG. 4 is an enlarged plan view of a portion of a display region of a display panel according to an embodiment of the invention;
FIG. 5 is a cross-sectional view of a display panel according to an embodiment of the invention;
FIG. 6 is a cross-sectional view of a display panel according to an embodiment of the invention;
FIG. 7 is a flowchart of a method for manufacturing a display panel according to an embodiment of the invention; and
FIGS. 8A to 16B are cross-sectional views illustrating operations of a method for manufacturing a display panel according to an embodiment of the invention, respectively.

### DETAILED DESCRIPTION

In the invention, various modifications may be made and various forms may be applied, and specific embodiments will be illustrated in the drawings and described in detail in the text. However, this is not intended to limit the invention to a specific disclosure form, it should be understood to include all changes, equivalents, and substitutes included in the scope of the invention.

In this specification, when a component (or region, layer, portion, etc.) is referred to as "on", "connected", or "coupled" to another component, it means that it is placed/connected/coupled directly on the other component or a third component can be disposed between them.

Meanwhile, in the present application, "directly disposed" may mean that there is no layer, film, region, plate, etc. added between a portion such as a layer, film, region, or plate and another portion. For example, "directly disposed" may mean placing two layers or two members without using an additional member such as an adhesive member therebetween.

The same reference numerals or symbols refer to the same elements. In addition, in the drawings, thicknesses, ratios, and dimensions of components are exaggerated for effective description of technical content.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." "And/or" includes all combinations of one or more that the associated elements may define.

Terms such as "first" and "second" may be used to describe various components, but the components should not be limited by the terms. These terms are only used for the purpose of distinguishing one component from other components. For example, without departing from the scope of the present invention, a first component may be referred to as a second component, and similarly, a second component may be referred to as a first component. Singular expressions include plural expressions unless the context clearly indicates otherwise.

In addition, terms such as "below", "lower", "above", and "upper" are used to describe the relationship between components shown in the drawings. The terms are relative concepts and are described based on the directions indicated in the drawings.

Terms such as "include" or "have" are intended to designate the presence of a feature, number, step, action, component, part, or combination thereof described in the specification, and it should be understood that it does not preclude the possibility of presence or addition of one or more other features, numbers, steps, operations, components, parts, or combinations thereof.

Unless otherwise defined, all terms (including technical and scientific terms) used in this specification have the same meaning as commonly understood by one of ordinary skill in the art to which this invention belongs. In addition, terms such as terms defined in commonly used dictionaries should be interpreted as having a meaning consistent with the meaning having in the context of the related technology, and should not be interpreted as too ideal or too formal unless explicitly defined here.

Hereinafter, embodiments of the invention will be described with reference to the drawings.

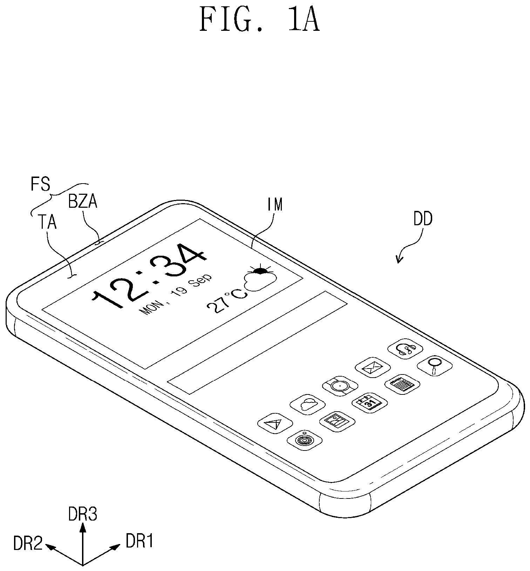

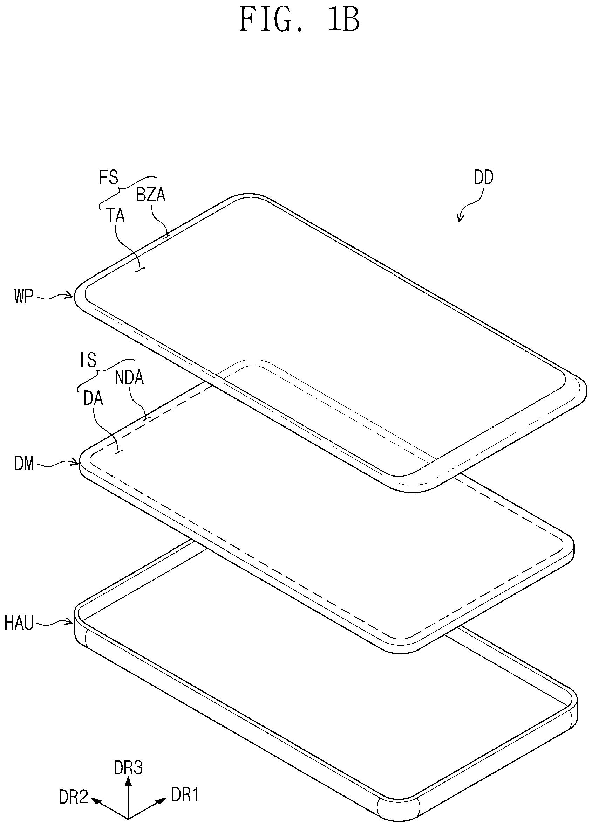

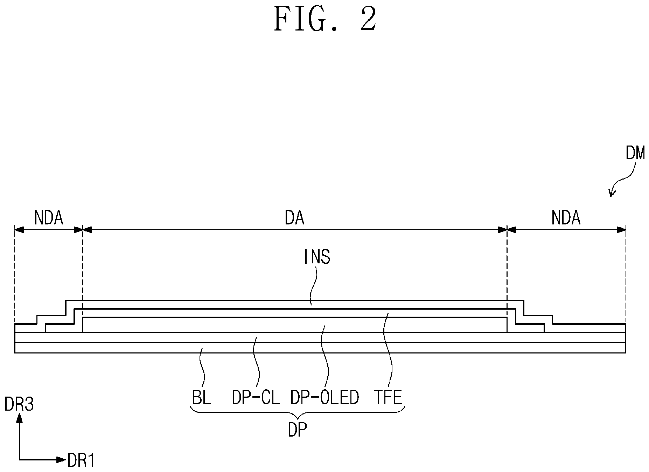

FIG. 1A is a combined perspective view of a display device DD according to an embodiment of the invention. FIGS. 1B is an exploded perspective view of the display device DD according to an embodiment of the invention. FIG. 2 is a cross-sectional view of a display module DM according to an embodiment of the invention.

The display device DD according to an embodiment may be a large-sized electronic device such as a television, a monitor, and a billboard. In addition, the display device DD may be a small- and medium-sized electronic device such as a personal computer, a notebook computer, a private digital terminal, a car navigation unit, a game console, a smartphone, a tablet computer, and a camera. These are suggested as only embodiments, and other display devices may be adopted as embodiments as long as not being deviated from the concept of the invention. In the present embodiment, a smartphone is illustrated as an example of the display device DD.

Referring to FIG. 1A, the display device DD may display an image IM, toward a third direction DR3, on a display surface FS parallel to each of a first direction DR1 and a second direction DR2. The image IM may include a static image as well as a dynamic image. A clock window and icons are illustrated as an example of the image IM in FIG. 1A. The display surface FS on which the image IM is displayed may correspond to the front surface of the display device DD.

In the present embodiment, the front surface (or upper surface) and the rear surface (or lower surface) of each member are defined with respect to a direction in which the image IM is displayed. The front surface and the rear surface may be opposed to each other in the third direction DR3, and a normal direction of each of the front surface and the rear surface may be parallel to the third direction DR3. Meanwhile, directions indicated by the first to third directions DR1, DR2, and DR3 are relative concepts, and may be changed to other directions. In the present disclosure, the wording, "on a plane" may mean when viewed in the third direction DR3 (i.e., in a plan view).

Referring to FIG. 1B, the display device DD according to an embodiment may include a window WP, a display module DM, and a housing HAU. The window WP and the housing HAU may be coupled to each other to constitute an exterior of the display device DD.

The window WP may include an optically transparent insulating material. In an embodiment, for example, the window WP may include glass or plastic. The front surface of the window WP may define the display surface FS of the display device DD.

The display surface FS may include a transmission region TA and a bezel region BZA. The transmission region TA may be an optically transparent region. In an embodiment, for example, the transmission region TA may have a visible light transmittance of about 90% or more. The bezel region BZA may have a relatively lower light transmittance than the transmission region TA. The bezel region BZA may define a shape of the transmission region TA. The bezel region BZA may be adjacent to the transmission region TA, and may surround the transmission region TA. Meanwhile, this is illustrated as an example, and in the window WP according to an embodiment of the invention, the bezel region BZA may be omitted. The window WP may further include at least any one functional layer among an anti-fingerprint layer, a hard-coating layer, and an anti-reflective layer, and is not limited to any one embodiment.

The display module DM may be disposed under the window WP. The display module DM may be a configuration that substantially generates the image IM (see FIG. 1A). The image IM (see FIG. 1A) generated by the display module DM may be displayed on a display surface IS of the display module DM, and may be viewed to an external user through the transmission region TA.

The display module DM may include a display region DA and a non-display region NDA. The display region DA may be activated in response to an electrical signal. The non-display region NDA is adjacent to the display region DA. The non-display region NDA may surround the display region DA. The non-display region NDA may be covered by the bezel region BZA not to be viewed from the outside.

Referring to FIG. 2, the display module DM according to the present embodiment may include a display panel DP and an input sensor INS. Although not separately shown, the display module DM according to an embodiment of the invention may further include a protective member disposed under the display panel DP, or an anti-reflective member disposed on the input sensor INS.

The display panel DP may be a light-emitting display panel, but is not specially limited thereto. In an embodiment, for example, the display panel DP may be an organic light-emitting display panel or an inorganic light-emitting display panel. A light-emitting layer in the organic light-emitting display panel may include an organic light-emitting material. A light-emitting layer in the inorganic light-emitting display panel may include a quantum dot, a quantum rod, or a micro-LED. Hereinafter, the display panel DP will be described as the organic light-emitting display panel.

The display panel DP may include a base layer BL, a circuit element layer DP-CL, a display element layer DP-OLED, and a thin-film encapsulation layer TFE. The input sensor INS may be directly disposed on the thin-film encapsulation layer TFE.

The base layer BL may be a member providing a base surface on which the circuit element layer DP-CL is disposed. The base layer BL may be a rigid substrate, or a flexible, bendable, foldable, or rollable substrate. The base layer BL may be a glass substrate, a metal substrate, a polymer substrate, or the like. However, an embodiment of the invention is not limited thereto, and the base layer BL may be an inorganic layer, an organic layer, or a composite material layer.

The circuit element layer DP-CL may be disposed on the base layer BL. The circuit element layer DP-CL may include an insulating layer, a semiconductor pattern, a conductive pattern, a signal line, etc. An insulating layer, a semiconductor layer, and a conductive layer may be formed on the base layer BL in a manner such as coating or deposition, and then the insulating layer, the semiconductor layer, and the conductive layer may be selectively patterned by performing a photolithography process and an etching process multiple times. Thereafter, the semiconductor pattern, the conductive pattern, and the signal line included in the circuit element layer DP-CL may be formed.

The display element layer DP-OLED may be disposed on the circuit element layer DP-CL. The display element layer DP-OLED may include a light-emitting element. In an embodiment, for example, the light-emitting element may include an organic light-emitting material, an inorganic light-emitting material, an organic-inorganic light-emitting material, a quantum dot, a quantum rod, a micro-LED, or a nano-LED.

The thin-film encapsulation layer TFE may be disposed on the display element layer DP-OLED. The thin-film encapsulation layer TFE may cover the display element layer DP-OLED. The thin-film encapsulation layer TFE may protect the display element layer DP-OLED from foreign matters such as moisture, oxygen, and dust particles.

The input sensor INS may be disposed on the display panel DP. The input sensor INS may sense an external input applied from the outside. The external input may be a user's input. The user's input may include various forms of external inputs such as a part of a user's body, light, heat, pen, or pressure. In an embodiment, for example, the input sensor INS may sense the external input in a capacitive manner. An operation manner of the input sensor INS according to the invention is not specially limited thereto, and the input sensor INS may sense the external input in an electromagnetic induction manner or a pressure-sensing manner.

The input sensor INS may be formed on the display panel DP through a continuous process. In this case, the input sensor INS may be directly disposed on the display panel DP. That is, a separate adhesive member may not be disposed between the input sensor INS and the display panel DP. In an embodiment, for example, the input sensor INS may be directly disposed on the thin-film encapsulation layer TFE of the display panel DP. Alternatively, the input sensor INS may be coupled to the display panel DP through an adhesive member. The adhesive member may include a typical adhesive or bonding agent.

The input sensor INS may have a multi-layered structure. The input sensor INS may include a single-layered or multi-layered conductive layer. The input sensor INS may include a single-layered or multi-layered insulating layer,

An optical layer (not shown) may be further disposed on the input sensor INS. The optical layer may be directly disposed on the input sensor INS. The optical layer may be formed on the input sensor INS through a continuous process. The optical layer may reduce reflectance of external light incident from the outside. The optical layer may include a polarizing layer or a color filter layer.

In an embodiment, the input sensor INS may be omitted, and the optical layer may be directly disposed on the display panel DP. In an embodiment, a position of the input sensor INS and a position of the optical layer may be changed to each other.

Referring to FIG. 1B again, the housing HAU may be coupled to the window WP to supply a predetermined inner space. The display module DM may be accommodated in the inner space.

The housing HAU may include a relatively rigid material. In an embodiment, for example, the housing HAU may include a plurality of frames and/or plates including glass, plastic, or metal, or composed of a combination thereof. The housing HAU may stably protect configurations of the display device DD accommodated in the inner space from an external impact.

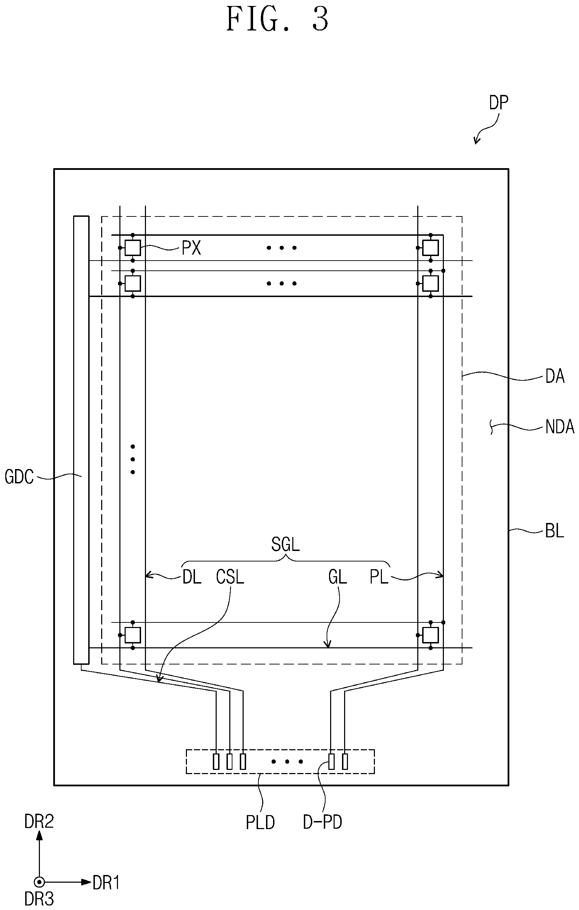

FIG. 3 is a plan view of a display panel DP according to an embodiment of the invention.

Referring to FIG. 3, the display panel DP may include a base layer BL divided into a display region DA and a non-display region NDA described with reference to FIG. 2.

The display panel DP may include pixels PX disposed in the display region DA, and signal line SGL electrically connected to the pixels PX. The display panel DP may include a driving circuit GDC and a pad portion PLD disposed in the non-display region NDA.

The pixels PX may be arranged in the first direction DR1 and the second direction DR2. The pixels PX may include a plurality of pixel rows extending in the first direction DR1 and arranged in the second direction DR2, and a plurality of pixel columns extending in the second direction DR2 and arranged in the first direction DR1.

The signal lines SGL may include gate lines GL, data lines DL, a power line PL, and a control signal line CSL. The gate lines GL may be connected to corresponding pixels among the pixels PX, respectively, and the data lines DL may be connected to corresponding pixels among the pixels PX, respectively. The power line PL may be electrically connected to the pixels PX. The control signal line CSL may be connected to the driving circuit GDC to supply control signals to the driving circuit GDC.

The driving circuit GDC may include a gate-driving circuit. The gate-driving circuit may generate gate signals and may sequentially output the generated signals to the gate lines GL. The gate-driving circuit may further output another control signal to a pixel-driving circuit.

The pad portion PLD may be a portion to which a flexible circuit board is connected. The pad portion PLD may include pixel pads D-PD, and the pixel pads D-PD may connect the flexible circuit board to the display panel DP. Each of the pixel pads D-PD may be connected to a corresponding signal line among the signal lines SGL. The pixel pads D-PD may be connected to corresponding pixels PX through the signal line SGL, respectively. In addition, one pixel pad among the pixel pads D-PD may be connected to the driving circuit GDC.

In addition, the pad portion PLD may further include input pads. The input pads may connect the flexible circuit board to the input sensor INS (see FIG. 2). However, an embodiment of the invention is not limited thereto, and the input pads may be disposed in the input sensor INS (see FIG. 2) to be connected to a circuit board separate from the pixel pads D-PD. Alternatively, the input sensor INS (see FIG. 2) may be omitted, and may not further include the input pads.

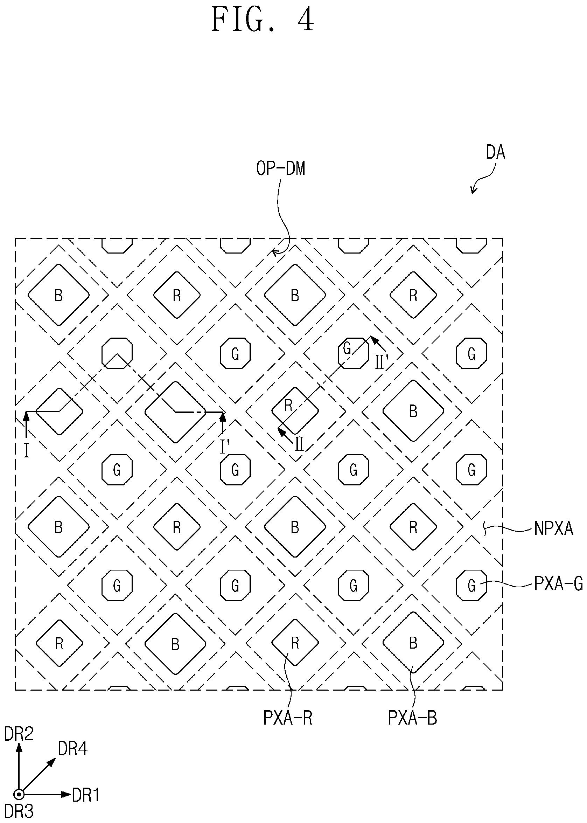

FIG. 4 is an enlarged plan view of a portion of a display region DA of a display panel according to an embodiment of the invention.

FIG. 4 illustrates a plane of a display module DM (see FIG. 1B) viewed on a display surface IS (see FIG. 1B), and an arrangement of light-emitting regions PXA-R, PXA-G, and PXA-B.

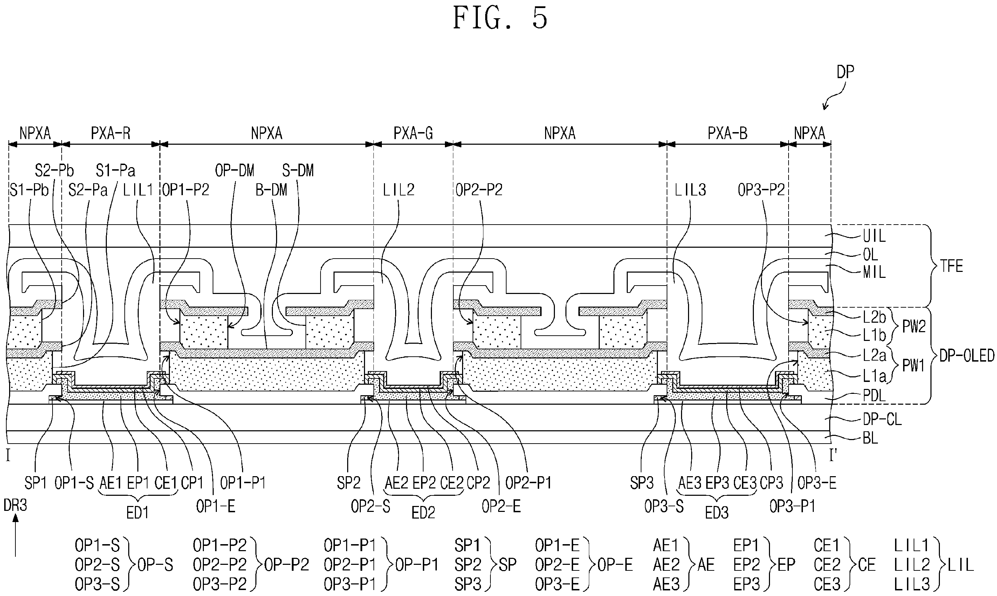

Referring to FIG. 4, the display region DA may include first to third light-emitting regions PXA-R, PXA-G, and PXA-B, and a peripheral region NPXA surrounding the first to third light-emitting regions PXA-R, PXA-G, and PXA-B. The first to third light-emitting regions PXA-R, PXA-G, and PXA-B may correspond to regions emitting light supplied by light-emitting elements ED1, ED2, and ED3 (see FIG. 5), respectively. The first to third light-emitting regions PXA-R, PXA-G, and PXA-B may be divided by colors of light emitted toward the outside of the display module DM (see FIG. 1B).

The first to third light-emitting regions PXA-R, PXA-G, and PXA-B may supply first to third color light having different colors, respectively. In an embodiment, for example, first color light may be red light, second color light may be green light, and third color light may be blue light. However, an example of the first to third color light are not necessarily limited to the example.

The first to third light-emitting regions PXA-R, PXA-G, and PXA-B may be defined as regions in which upper surfaces of first electrodes AE1, AE2, and AE3 (see FIG. 5), respectively, are exposed by light-emitting openings OP1-E, OP2-E, and OP3-E. The peripheral region NPXA may set boundaries of the first to third light-emitting regions PXA-R, PXA-G, and PXA-B, and may prevent color mixing between the first to third light-emitting regions PXA-R, PXA-G, and PXA-B.

Each of the first to third light-emitting regions PXA-R, PXA-G, and PXA-B are provided in plurality to be repeatedly disposed in the display region DA with a predetermined arrangement form. In an embodiment, for example, the first and third light-emitting regions PXA-R, and PXA-B may be alternately arranged along the first direction DR1 to constitute `a first group'. The second light-emitting regions PXA-G may be arranged along the first direction DR1 to constitute `a second group'. Each of 'the first group' and 'the second group' may be provided in plurality, and 'the first groups' and 'the second groups' may be alternately arranged along the second direction DR2.

One second light-emitting region PXA-G may be disposed spaced apart from one first light-emitting region PXA-R or one third light-emitting region PXA-B in a fourth direction DR4. The fourth direction DR4 may be defined as a direction between the first and second directions DR1 and DR2.

Meanwhile, FIG. 4 exemplarily illustrates an arrangement form of the first to third light-emitting regions PXA-R, PXA-G, and PXA-B, but an embodiment of the invention is not limited thereto, and the first to third light-emitting regions PXA-R, PXA-G, and PXA-B may be arranged in various forms. In an embodiment, the first to third light-emitting regions PXA-R, PXA-G, and PXA-B may have a PENTILE^{™} arrangement form as illustrated in FIG. 4. Alternatively, the first to third light-emitting regions PXA-R, PXA-G, and PXA-B may have a stripe arrangement form or a Diamond Pixel^{™} arrangement form.

The first to third light-emitting regions PXA-R, PXA-G, and PXA-B may have various shapes on a plane. In an embodiment, for example, the first to third light-emitting regions PXA-R, PXA-G, and PXA-B may have a shape such as a polygon, a circle, or an ellipse. FIG. 4 exemplarily illustrates the first and third light-emitting regions PXA-R and PXA-B having, on a plane, a tetragonal shape (or rhombus shape), and the second light-emitting region PXA-G having an octagonal shape.

The first to third light-emitting regions PXA-R, PXA-G, and PXA-B may have, on a plane, the same shape as each other, or at least a portion thereof may have shapes different from each other on a plane. FIG. 4 exemplarily illustrates the first and third light-emitting regions PXA-R and PXA-B having the same shape as each other and the second light-emitting region PXA-G having a shape different from the first and third light-emitting regions PXA-R and PXA-B.

At least a portion of the first to third light-emitting regions PXA-R, PXA-G, and PXA-B may have a different area on a plane. In an embodiment, an area of the first light-emitting region PXA-R emitting red light may be greater than an area of the second light-emitting region PXA-G emitting green light, and may be smaller than an area of the third light-emitting region PXA-B emitting blue light. However, small and large relationships between areas of the first to third light-emitting regions PXA-R, PXA-G, and PXA-B according to colors of light emitted thereby are not limited thereto, and may be various according to designing of the display module DM (see FIG. 1B). In addition, an embodiment of the invention is not limited thereto, and the first to third light-emitting regions PXA-R, PXA-G, and PXA-B may have the same area as each other on a plane.

Shapes, areas, arrangement, or the like of the first to third light-emitting regions PXA-R, PXA-G, and PXA-B of the display module DM (see FIG. 1B) according to the invention may be variously designed according to colors of emitted light, or a size and a configuration of the display module DM (see FIG. 1B), and is not limited to an embodiment illustrated in FIG. 4.

A dummy opening OP-DM may be disposed between the first to third light-emitting regions PXA-R, PXA-G, and PXA-B according to the invention. The dummy opening OP-DM may mean an opening defined on a first conductive partition wall PW1 (see FIG. 5) by a second conductive partition wall PW2 (see FIG. 5) to be described later. The dummy opening OP-DM may be disposed in the peripheral region NPXA between the first to third light-emitting regions PXA-R, PXA-G, and PXA-B.

FIG. 4 illustrates that the dummy opening OP-DM has an integrated shape connected to each other on a plane, but an embodiment of the invention is not limited thereto. Unlike what is illustrated in FIG. 4, the dummy opening OP-DM may be disposed spaced apart from each other with a plurality of shapes independent of each other. In an embodiment, for example, the plurality of dummy openings OP-DM may be disposed between the first light-emitting region PXA-R and the second light-emitting region PXA-G, and between the second light-emitting region PXA-G and the third light-emitting region PXA-B, respectively.

In addition, FIG. 4 illustrates that one dummy opening OP-DM is disposed between adjacent light-emitting regions PXA-R, PXA-G, and PXA-B, but an embodiment of the invention is not limited thereto. Unlike what is illustrated in FIG. 4, two or more dummy openings OP-DM may be disposed between adjacent light-emitting regions PXA-R, PXA-G, and PXA-B.

FIG. 5 is a cross-sectional view of a display panel DP according to an embodiment of the invention. FIG. 5 is an embodiment of a cross-section taken along line I-I' in FIG. 4.

Referring to FIG. 5, the display panel DP may include a base layer BL, a circuit element layer DP-CL, a display element layer DP-OLED, and a thin-film encapsulation layer TFE.

The display panel DP may include a plurality of insulating layers, a semiconductor pattern, a conductive pattern, a signal line, etc. An insulating layer, a semiconductor layer, and a conductive layer are formed in a manner such as coating or deposition. Thereafter, the insulating layer, the semiconductor layer, and the conductive layer may be selectively patterned by photolithography and etching. The semiconductor pattern, the conductive pattern, the signal line, etc., included in the circuit element layer DP-CL and the display element layer DP-OLED may be formed in such manners.

The circuit element layer DP-CL may be disposed on the base layer BL. The circuit element layer DP-CL may include a buffer layer, a transistor, a signal transmission region, a plurality of insulating layers, and a plurality of connection electrodes.

The buffer layer may be disposed on the base layer BL. The buffer layer may improve a binding force between the base layer BL and the semiconductor pattern. The buffer layer may include a silicon oxide layer and a silicon nitride layer. The silicon oxide layer and the silicon nitride layer may be alternately stacked.

The semiconductor pattern may be disposed on the buffer layer. The semiconductor pattern may include polycrystalline silicon. However, an embodiment of the invention is not limited thereto, and the semiconductor pattern may include amorphous silicon or metal oxide. The semiconductor pattern may be arranged over a plurality of light-emitting regions with a specific rule. The semiconductor pattern may have an electrical property different according to whether or not being doped. The semiconductor pattern may include a first region having a great doping concentration and a second region having a small doping concentration. The first region may be doped with an n-type dopant or a p-type dopant. A p-type transistor may include the first region doped with the p-type dopant.

The first region has a greater conductive property than the second region, and substantially serves as an electrode or a signal line. The second region may substantially correspond to an active (or channel) of the transistor. In other words, a portion of the semiconductor pattern may be the active of the transistor, and another portion thereof may be a source or a drain, and still another portion thereof may be a conductive region. The source, the active, and the drain of the transistor may be formed from the semiconductor pattern.

The plurality of insulating layers may be disposed on the buffer layer. The plurality of insulating layers may be each an inorganic layer or an organic layer.

The display element layer DP-OLED may be disposed on the circuit element layer DP-CL. The display element layer DP-OLED may include light-emitting elements ED1, ED2, and ED3, a pixel-defining film PDL, a first conductive partition wall PW1, and a second conductive partition wall PW2.

The light-emitting elements ED1, ED2, and ED3 may include first electrodes AE1, AE2, and AE3, light-emitting patterns EP1, EP2, and EP3, and second electrodes CE1, CE2, and CE3, respectively.

A light-emitting element ED1 disposed in the first light-emitting region PXA-R may be referred to as a first light-emitting element. A light-emitting element ED2 disposed in the second light-emitting region PXA-G may be referred to as a second light-emitting element. A light-emitting element ED3 disposed in the third light-emitting region PXA-B may be referred to as a third light-emitting element.

The first electrodes AE1, AE2, and AE3 may be disposed on the circuit element layer DP-CL. The first electrodes AE1, AE2, and AE3 may be anodes. The first electrodes AE1, AE2, and AE3 may be a transmissive electrode, a semi-transmissive electrode, or a reflective electrode. The first electrodes AE1, AE2, and AE3 may have a conductive property. In an embodiment, for example, the first electrodes AE1, AE2, and AE3 may be formed of various materials, such as metal, transparent conductive oxide (TCO), or a conductive polymer material, having a conductive property.

The first electrodes AE1, AE2, and AE3 may be electrically connected to a signal transmission region SCL (see FIG. 3) through connection electrodes (not shown), and thus may be electrically connected to corresponding circuit elements, respectively.

The display panel DP may further include sacrificial patterns SP1, SP2, and SP3. The sacrificial patterns SP1, SP2, and SP3 may be disposed on upper surfaces of the first electrodes AE1, AE2, and AE3, respectively. Sacrificial openings OP1-S, OP2-S, and OP3-S partially exposing upper surfaces of the first electrodes AE1, AE2, and AE3 may be defined in the sacrificial patterns SP1, SP2, and SP3. The sacrificial patterns SP1, SP2, and SP3 may include amorphous transparent conductive oxide.

The pixel-defining film PDL may be disposed on the circuit element layer DP-CL. Light-emitting openings OP1-E, OP2-E, and OP3-E may be defined in the pixel-defining film PDL. The light-emitting openings OP1-E, OP2-E, and OP3-E may overlap the first electrodes AE1, AE2, and AE3, respectively, in the plan view, and the pixel-defining film PDL may expose at least a portion of the first electrodes AE1, AE2, and AE3 through the light-emitting openings OP1-E, OP2-E, and OP3-E.

The light-emitting openings OP1-E, OP2-E, and OP3-E may overlap the sacrificial openings OP1-S, OP2-S, and OP3-S defined by the sacrificial patterns SP1, SP2, and SP3, respectively, in the plan view. The upper surfaces of the first electrodes AE1, AE2, and AE3 may be spaced apart from the pixel-defining film PDL on a cross-section with the sacrificial patterns SP1, SP2, and SP3 therebetween, and thus may protect the first electrodes AE1, AE2, and AE3 from being damaged in a process of forming the light-emitting openings OP1-E, OP2-E, and OP3-E.

On a plane, areas of the light-emitting openings OP1-E, OP2-E, and OP3-E may be smaller than areas of the sacrificial openings OP1-S, OP2-S, and OP3-S, respectively. That is, inner side surfaces of the pixel-defining film PDL defining the light-emitting openings OP1-E, OP2-E, and OP3-E may be respectively more adjacent to the centers of the first electrodes AE1, AE2, and AE3 than inner side surfaces of the sacrificial patterns SP1, SP2, and SP3 defining the sacrificial openings OP1-S, OP2-S, and OP3-S, respectively. However, an embodiment of the invention is not limited thereto, and the inner side surfaces of the sacrificial patterns SP1, SP2, and SP3 defining the sacrificial openings OP1-S, OP2-S, and OP3-S, respectively, may be substantially aligned to the inner side surfaces of the pixel-defining film PDL defining the light-emitting openings OP1-E, OP2-E, and OP3-E. In this case, the first to third light-emitting regions PXA-R, PXA-G, and PXA-B may be regions of the first electrodes AE1, AE2, and AE3 exposed from the sacrificial openings OP1-S, OP2-S, and OP3-S corresponding thereto. The sacrificial patterns SP1, SP2, and SP3 may be omitted.

The pixel-defining film PDL may include an inorganic insulating material. In an embodiment, for example, the pixel-defining film PDL may include silicon nitride (SiNₓ). The pixel-defining film PDL may be disposed between the first electrodes AE1, AE2, and AE3 and the first conductive partition wall PW1, and thus may block the first electrodes AE1, AE2, and AE3 and the first conductive partition wall PW1 from being electrically connected to each other.

The first conductive partition wall PW1 may be disposed on the pixel-defining film PDL. The first partition wall openings OP1-P1, OP2-P1, and OP3-P1 may be defined in the first conductive partition wall PW1. The first partition wall openings OP1-P1, OP2-P1, and OP3-P1 may overlap the light-emitting openings OP1-E, OP2-E, and OP3-E in the plan view, and may expose at least a portion of the first electrodes AE1, AE2, and AE3, respectively.

The first conductive partition wall PW1 may have an undercut shape on a cross-section. The first conductive partition wall PW1 may include multiple layers sequentially stacked, and at least one layer of the multiple layers may be relatively further recessed than adjacent stacked layers. Accordingly, the first conductive partition wall PW1 may include a tip portion. The tip portion of the first conductive partition wall PW1 may be defined as a first tip portion.

The first conductive partition wall PW1 may include a first lower layer L1a and a second lower layer L2a. The first lower layer L1a may be disposed on the pixel-defining film PDL, and the second lower layer L2a may be disposed on the first lower layer L1a. The first lower layer L1a may have a first conductive property, and the second lower layer L2a may have a second conductive property smaller than the first conductive property. A thickness of the first lower layer L1a may be greater than a thickness of the second lower layer L2a.

The first lower layer L1a may be relatively further recessed than the second lower layer L2a in the light-emitting regions PXA-R, PXA-G, and PXA-B. The second lower layer L2a may relatively further protrude than the first lower layer L1a in the first to third light-emitting regions PXA-R, PXA-G, and PXA-B. That is, the first lower layer L1a may be formed to have an undercut shape with respect to the second lower layer L2a. A portion, of the second lower layer L2a, protruding from the first lower layer L1a toward the light-emitting regions PXA-R, PXA-G, and PXA-B may correspond to the first tip portion described above.

A first partition wall opening OP1-P1 defined in the first conductive partition wall PW1 may include a first lower inner side surface S1-Pa and a second lower inner side surface S2-Pa sequentially arranged in the third direction DR3. The first lower inner side surface S1-Pa may be an inner side surface of the first lower layer L1a, and the second lower inner side surface S2-Pa may be an inner side surface of the second lower layer L2a. The first lower inner side surface S1-Pa and the second lower inner side surface S2-Pa may be identically included in first partition wall openings OP2-P1 and OP3-P1 corresponding to the second and third light-emitting regions PXA-G and PXA-B.

The first lower inner side surface S1-Pa of the first lower layer L1a may be disposed recessed in a direction farther from the light-emitting region PXA-R than the second lower inner side surface S2-Pa of the second lower layer L2a. That is, the first lower inner side surface S1-Pa may be formed to have an undercut shape with respect to the second lower inner side surface S2-Pa.

The first lower layer L1a and the second lower layer L2a may each include a conductive material. The first lower layer L1a may include metal. In an embodiment, for example, the first lower layer L1a may include aluminium (Al). However, a material of the first lower layer L1a is not limited thereto. The second lower layer L2a may include metal. In an embodiment, for example, the second lower layer L2a may include titanium (Ti).

FIG. 5 exemplarily illustrates that the first and second lower inner side surfaces S1-Pa and S2-Pa are each orthogonal with respect to an upper surface of the pixel-defining film PDL, but an embodiment of the invention is not limited thereto. The first conductive partition wall PW1 may have a taper shape, or a reverse-taper shape.

The light-emitting patterns EP1, EP2, and EP3 may be disposed on the first electrodes AE1, AE2, and AE3. The light-emitting patterns EP1, EP2, and EP3 may be patterned by the first tip portion defined in the first conductive partition wall PW1. The light-emitting patterns EP1, EP2, and EP3 may be disposed in the light-emitting openings OP1-E, OP2-E, and OP3-E and the first partition wall openings OP1-P1, OP2-P1, and OP3-P1. In an embodiment including the sacrificial patterns SP1, SP2, and SP3, the light-emitting patterns EP1, EP2, and EP3 may be also disposed in the sacrificial openings OP1-S, OP2-S, and OP3-S. The light-emitting patterns EP1, EP2, and EP3 may partially cover the upper surface of the pixel-defining film PDL exposed from the first partition wall openings OP1-P1, OP2-P1, and OP3-P1.

The light-emitting patterns EP1, EP2, and EP3 may each include a light-emitting layer including a light-emitting material. The light-emitting patterns EP1, EP2, and EP3 may each further include a hole injection layer (HIL) and/or a hole transport layer HTL disposed between the first electrodes AE1, AE2, and AE3 and the light-emitting layer, and may each further include an electron transport layer (ETL) and/or an electron injection layer (EIL) disposed on the light-emitting layer. The light-emitting patterns EP1, EP2, and EP3 may be each referred to as 'an organic layer' or `an intermediate layer'.

The second electrodes CE1, CE2, and CE3 may be disposed on the light-emitting patterns EP1, EP2, and EP3, respectively. The second electrodes CE1, CE2, and CE3 may be cathodes. The second electrodes CE1, CE2, and CE3 may be patterned by the first tip portion defined in the first conductive partition wall PW1. The second electrodes CE1, CE2, and CE3 may be disposed in the first partition wall openings OP1-P1, OP2-P1, and OP3-P1, respectively. According to thicknesses of the light-emitting patterns EP1, EP2, and EP3 or a thickness of the pixel-defining film PDL, the second electrodes CE1, CE2, and CE3 may be also partially disposed in the light-emitting openings OP1-E, OP2-E, and OP3-E.

The second electrodes CE1, CE2, and CE3 may be in contact with the first lower inner side surface S1-Pa of the first lower layer L1a. The second electrodes CE1, CE2, and CE3 may have a conductive property. In an embodiment, for example, the second electrodes CE1, CE2, and CE3 may be formed of various materials, such as metal, transparent conductive oxide (TCO), or a conductive polymer material, having a conductive property.

In the present embodiment, the first conductive partition wall PW1 may receive a bias voltage. The second electrodes CE1, CE2, and CE3 may be each electrically connected to the first conductive partition wall PW1, and thus may be supplied with the bias voltage.

FIG. 5 exemplarily illustrates that the light-emitting patterns EP1, EP2, and EP3 are not in contact with the first lower inner side surface S1-Pa of the first lower layer L1a, but an embodiment of the invention is not limited thereto. Not only the second electrodes CE1, CE2, and CE3 but also the light-emitting patterns EP1, EP2, and EP3 may be formed to be in contact with the first lower inner side surface S1-Pa of the first lower layer L1a.

The display panel DP may further include the capping patterns CP1, CP2, and CP3. The capping patterns CP1, CP2, and CP3 may be disposed on the second electrodes CE1, CE2, and CE3, and in the first partition wall openings OP1-P1, OP2-P1, and OP3-P1, respectively. The capping patterns CP1, CP2, and CP3 may be patterned by the first tip portion formed in the first conductive partition wall PW1.

FIG. 5 exemplarily illustrates that the capping patterns CP1, CP2, and CP3 are not in contact with the first lower inner side surface S1-Pa of the first lower layer L1a, but an embodiment of the invention is not limited thereto. The capping patterns CP1, CP2, and CP3 may be formed to be in contact with the first lower inner side surface S1-Pa of the first lower layer L1a. In an embodiment, the capping patterns CP1, CP2, and CP3 may be omitted.

The second conductive partition wall PW2 may be disposed on the first conductive partition wall PW1. Second partition wall openings OP1-P2, OP2-P2, and OP3-P2 and a dummy opening OP-DM may be defined in the second conductive partition wall PW2.

The second partition wall openings OP1-P2, OP2-P2, and OP3-P2 may overlap the light-emitting openings OP1-E, OP2-E, and OP3-E and the first partition wall openings OP1-P1, OP2-P1, and OP3-P1 in the plan view, and may expose at least a portion of the first electrodes AE1, AE2, and AE3, respectively.

The second conductive partition wall PW2 may have an undercut shape on a cross-section. The second conductive partition wall PW2 may include multiple layers sequentially stacked, and at least one layer of the multiple layers may be relatively further recessed than adjacent stacked layers. Accordingly, the second conductive partition wall PW2 may include a tip portion. The tip portion of the second conductive partition wall PW2 may be defined as a second tip portion.

The second conductive partition wall PW2 may include a first upper layer L1b and a second upper layer L2b. The first upper layer L1b may be disposed on the first conductive partition wall PW1, and the second upper layer L2b may be disposed on the first upper layer L1b. A thickness of the first upper layer L1b may be greater than a thickness of the second upper layer L2b.

In the present embodiment, the first upper layer L1b may be relatively further recessed than the second upper layer L2b with respect to the light-emitting regions PXA-R, PXA-G, and PXA-B. The second upper layer L2b may relatively further protrude than the first upper layer L1b with respect to the light-emitting regions PXA-R, PXA-G, and PXA-B. That is, the first upper layer L1b may be formed to have an undercut shape with respect to the second upper layer L2b. A portion, of the second upper layer L2b, protruding from the first upper layer L1b toward the light-emitting regions PXA-R, PXA-G, and PXA-B may correspond to the second tip portion described above.

A second partition wall opening OP1-P2 defined in the second conductive partition wall PW2 may include a first upper inner side surface S1-Pb and a second upper inner side surface S2-Pb sequentially arranged in the third direction DR3. The first upper inner side surface S1-Pb may be an inner side surface of the first upper layer L1b, and the second upper inner side surface S2-Pb may be an inner side surface of the second upper layer L2b. The first upper inner side surface S1-Pb and the second upper inner side surface S2-Pb may be identically included in the second partition wall openings OP2-P2 and OP3-P2 corresponding to the second and third light-emitting regions PXA-G and PXA-B.

The first upper inner side surface S1-Pb of the first upper layer L1b may be disposed recessed than the second upper inner side surface S2-Pb of the second upper layer L2b in a direction farther from the light-emitting region PXA-R. That is, the first upper inner side surface S1-Pb may be formed to have an undercut shape with respect to the second upper inner side surface S2-Pb.

The first upper layer L1b and the second upper layer L2b may each include a conductive material. The first upper layer L1b may include metal. In an embodiment, for example, the first upper layer L1b may include aluminium (Al), but a material of the first upper layer L1b is not limited thereto. The second upper layer L2b may include metal. In an embodiment, for example, the second upper layer L2b may include titanium (Ti).

FIG. 5 exemplarily illustrates that the first and second upper inner side surfaces S1-Pb and S2-Pb are each orthogonal with respect to an upper surface of the pixel-defining film PDL, but an embodiment of the invention is not limited thereto. The second conductive partition wall PW2 may have a taper shape, or a reverse-taper shape.

The second conductive partition wall PW2 may define the dummy opening OP-DM in the peripheral region NPXA. The dummy opening OP-DM may be defined by a side surface of the second conductive partition wall PW2 and an upper surface of the first conductive partition wall PW1. That is, a side surface S-DM of the dummy opening OP-DM may correspond to one of the side surfaces of the second conductive partition wall PW2, and a bottom surface B-DM of the dummy opening OP-DM may partially correspond to the upper surface of the first conductive partition wall PW1.

The second conductive partition wall PW2 may expose at least a portion of the upper surface of the first conductive partition wall PW1 in the peripheral region NPXA by the dummy opening OP-DM.

As in FIGS. 4 and 5, the second conductive partition wall PW2 may be a plurality of partition walls separated by the dummy opening OP-DM to be disposed spaced apart from each other. However, as described in FIG. 4, the dummy opening OP-DM may be disposed in a plurality having a shape in which the dummy openings OP-DM are spaced apart from each other, and in this case, the second conductive partition wall PW2 may be an integrated partition wall defining a plurality of dummy openings OP-DM.

In addition, as in FIGS. 4 and 5, one dummy opening OP-DM may be disposed between adjacent light-emitting regions PXA-R, PXA-G, and PXA-B. However, as described in FIG. 4, two or more dummy openings OP-DM may be disposed between adjacent light-emitting regions PXA-R, PXA-G, and PXA-B. In an embodiment, for example, when viewed on a cross-section, three second conductive partition walls PW2 may be disposed between the light-emitting regions PXA-R, PXA-G, and PXA-B, and two dummy openings OP-DM may be defined between the light-emitting regions PXA-R, PXA-G, and PXA-B.

The thin-film encapsulation layer TFE may be disposed on the display element layer DP-OLED. The thin-film encapsulation layer TFE may include an inorganic lower encapsulation pattern LIL (or an inorganic pattern), an organic encapsulation film OL, and an inorganic upper encapsulation film UIL. The thin-film encapsulation layer TFE may further include an inorganic intermediate encapsulation film MIL.

The inorganic lower encapsulation pattern LIL may cover the light-emitting element ED. Specifically, the inorganic lower encapsulation pattern LIL may be disposed on the second electrodes CE1, CE2, and CE3 to cover the second electrodes CE1, CE2, and CE3, and the capping patterns CP1, CP2, and CP3 disposed on the second electrodes CE1, CE2, and CE3 together.

The inorganic lower encapsulation pattern LIL may be referred to as an inorganic lower encapsulation film. The inorganic lower encapsulation pattern LIL may include a first inorganic lower encapsulation pattern LIL1 disposed corresponding to the first light-emitting region PXA-R, a second inorganic lower encapsulation pattern LIL2 disposed corresponding to the second light-emitting region PXA-G, and a third inorganic lower encapsulation pattern LIL3 disposed corresponding to the third light-emitting region PXA-B.

A portion of the inorganic lower encapsulation pattern LIL may be disposed in the light-emitting openings OP1-E, OP2-E, and OP3-E, the first partition wall openings OP1-P1, OP2-P1, and OP3-P1, and the second partition wall openings OP1-P2, OP2-P2, and OP3-P2. According to thicknesses of the light-emitting patterns EP1, EP2, and EP3, the second electrodes CE1, CE2, and CE3, and the capping patterns CP1, CP2, and CP3, or a thickness of the pixel-defining film PDL, the inorganic lower encapsulation pattern LIL may not be disposed in the light-emitting openings OP1-E, OP2-E, and OP3-E.

The inorganic lower encapsulation pattern LIL may be in contact with the first and second lower inner side surfaces S1-Pa and S2-Pa of the first conductive partition wall PW1 defining the first partition wall openings OP1-P1, OP2-P1, and OP3-P1, and the first and second upper inner side surfaces S1-Pb and S2-Pb of the second conductive partition wall PW2 defining the second partition wall openings OP1-P2, OP2-P2, and OP3-P2, and may cover the first and second lower inner side surfaces S1-Pa and S2-Pa and the first and second upper inner side surfaces S1-Pb and S2-Pb. Specifically, a portion exposed by not being in contact with the second electrodes CE1, CE2, and CE3 with respect to the first lower inner side surface S1-Pa may be covered by the inorganic lower encapsulation pattern LIL.

The dummy opening OP-DM and the upper surface of the second conductive partition wall PW2 may not be covered by the inorganic lower encapsulation pattern LIL.

The inorganic intermediate encapsulation film MIL may cover the dummy opening OP-DM and the upper surface of the second conductive partition wall PW2 exposed by not being covered by the inorganic lower encapsulation pattern LIL. The inorganic intermediate encapsulation film MIL may be entirely disposed covering the inorganic lower encapsulation pattern LIL.

The display panel DP according to the invention may define the dummy opening OP-DM in the second conductive partition wall PW2, and may include the inorganic intermediate encapsulation film MIL that covers the dummy opening OP-DM and the upper surface of the second conductive partition wall PW2. Accordingly, contact areas of the first and second conductive partition walls PW1 and PW2 and the inorganic films LIL and MIL may increase. Specifically, the second conductive partition wall PW2 and the inorganic lower encapsulation pattern LIL may be in contact with each other in two side surface S-DM of the dummy opening OP-DM, the upper surface of the second conductive partition wall PW2 and the inorganic intermediate encapsulation film MIL may be in contact with each other, and the first conductive partition wall PW1 and the inorganic intermediate encapsulation film MIL may be in contact with each other in the bottom surface B-DM of the dummy opening OP-DM. Since the contact areas increase, the display panel DP according to the invention may prevent external moisture from infiltrating the light-emitting elements ED1, ED2, and ED3, thereby improving reliability of the display device DD (see FIG. 1).

The organic encapsulation film OL may cover the inorganic intermediate encapsulation film MIL, and may supply a flat upper surface. The inorganic upper encapsulation film UIL may be disposed on the organic encapsulation film OL.

The inorganic lower encapsulation pattern LIL, the inorganic intermediate encapsulation film MIL, and the inorganic upper encapsulation film UIL may protect the display element layer DP-OLED from moisture/oxygen, and the organic encapsulation film OL may protect the display element layer DP-OLED from foreign matters such as dust particles.

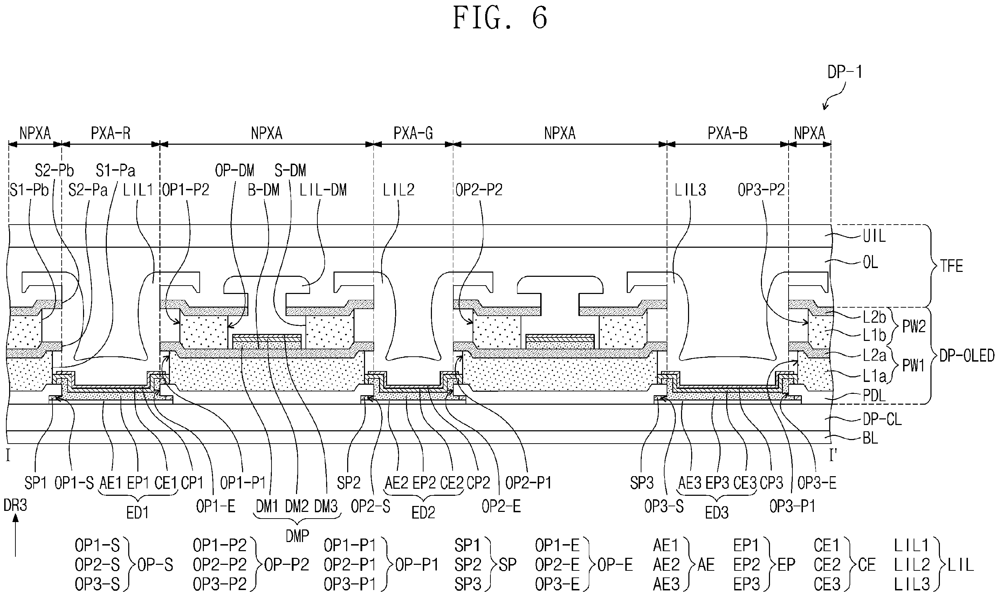

FIG. 6 is a cross-sectional view of a display panel DP-1 according to an embodiment of the invention. FIG. 6 is another embodiment of a cross-section taken along line I-I' in FIG. 4. Descriptions made in FIG. 5 may be identically applied except for those made hereinafter.

Referring to FIG. 6, the display panel DP-1 may include an inorganic dummy encapsulation film LIL-DM. The inorganic dummy encapsulation film LIL-DM may be disposed in the dummy opening OP-DM to cover the side surface S-DM and the bottom surface B-DM of the dummy opening OP-DM.

The inorganic dummy encapsulation film LIL-DM may include the same material as the inorganic lower encapsulation pattern LIL. Specifically, the inorganic dummy encapsulation film LIL-DM may be formed in the same process step as the first inorganic lower encapsulation pattern LIL1, the second inorganic lower encapsulation pattern LIL2, or the third inorganic lower encapsulation pattern LIL3.

Compared to the display panel DP in FIG. 5 in which the inorganic intermediate encapsulation film MIL is disposed in the dummy opening OP-DM, a dummy pattern DMP may be disposed in the dummy opening OP-DM. The dummy pattern DMP may be formed together in an operation of forming the first light-emitting element ED1, an operation of forming the second light-emitting element ED2, or an operation of forming the third light-emitting element ED3. The dummy pattern DMP may include a first dummy pattern DM1, a second dummy pattern DM2, and a third dummy pattern DM3. The first dummy pattern DM1 may include the same material as one of the light-emitting elements ED1, ED2, and ED3, and may be formed in the same process step. The second dummy pattern DM2 may include the same material as the second electrodes CE1, CE2, and CE3. The third dummy pattern DM3 may include the same material as the capping patterns CP1, CP2, and CP3.

In an embodiment, for example, the light-emitting pattern EP3, the second electrode CE3, the capping pattern CP3, and the inorganic lower encapsulation pattern LIL3 may be formed in an operation of forming the third light-emitting element ED3, and a photo process may be performed by patterning photoresist on the third light-emitting region PXA-B and a portion in which the dummy opening OP-DM is disposed.

In this case, the first dummy pattern DM1 may include the same material as and may be formed by the same process as the light-emitting pattern EP3 of the third light-emitting region PXA-B, the second dummy pattern DM2 may include the same material as and may be formed by the same process as the second electrode CE3 of the third light-emitting region PXA-B, the third dummy pattern DM3 may include the same material as and may be formed by the same process as the capping pattern CP3 of the third light-emitting region PXA-B, and the inorganic dummy encapsulation film LIL-DM may include the same material as and may be formed by the same process as the third inorganic lower encapsulation pattern LIL3.

Since the second conductive partition PW2 includes a tip portion, the dummy pattern DMP may not entirely cover the upper surface of the first conductive partition PW1 (that is, the bottom surface B-DM of the dummy opening OP-DM) exposed by the dummy opening OP-DM. Accordingly, a portion of the bottom surface B-DM of the dummy opening OP-DM may be covered by the dummy pattern DMP, and the rest thereof may be covered by the inorganic dummy encapsulation film LIL-DM.

The display panel DP-1 according to the invention may define the dummy opening OP-DM in the second conductive partition PW2, and may include the inorganic dummy encapsulation film LIL-DM that covers the dummy opening OP-DM. Accordingly, contact areas of the first and second conductive partitions walls PW1 and PW2 and the inorganic films LIL and LIL-DM may increase. Specifically, the second conductive partition wall PW2 and the inorganic dummy encapsulation film LIL-DM may be in contact with each other in two side surfaces S-DM of the dummy opening OP-DM, and the upper surface of the first conductive partition wall PW1 and the inorganic dummy encapsulation film LIL-DM may be in contact with each other in the bottom surface B-DM of the dummy opening OP-DM. When the contact areas increase, the display panel DP-1 according to the invention may prevent external moisture from infiltrating the light-emitting elements ED1, ED2, and ED3, thereby improving reliability of the display device DD (see FIG. 1).

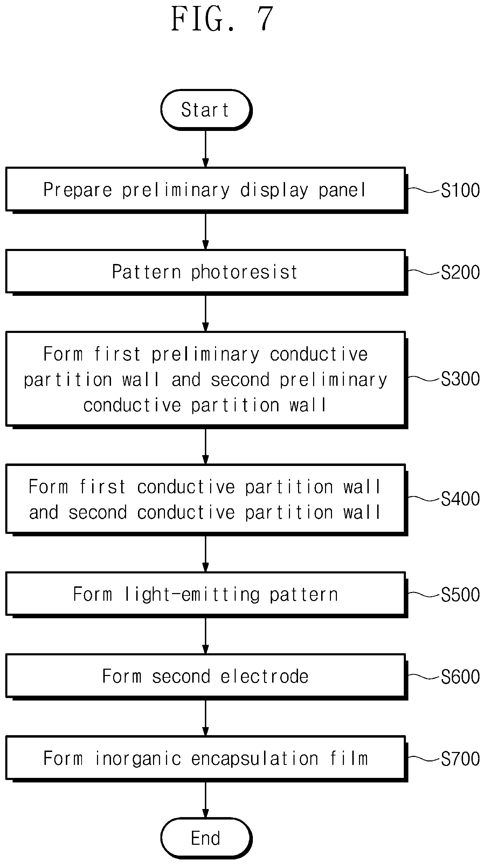

FIG. 7 is a flowchart of a method for manufacturing a display panel DP (see FIG. 5) according to an embodiment of the invention.

The method for manufacturing a display panel according to an embodiment may include an operation (S100) of preparing a preliminary display panel, an operation (S200) of patterning photoresist, an operation (S300) of forming a first preliminary conductive partition wall and a second preliminary conductive partition wall, an operation (S400) of forming a first conductive partition wall and a second conductive partition wall, an operation (S500) of forming a light-emitting pattern, an operation (S600) of forming a second electrode, and an operation (S700) of forming an inorganic encapsulation film.

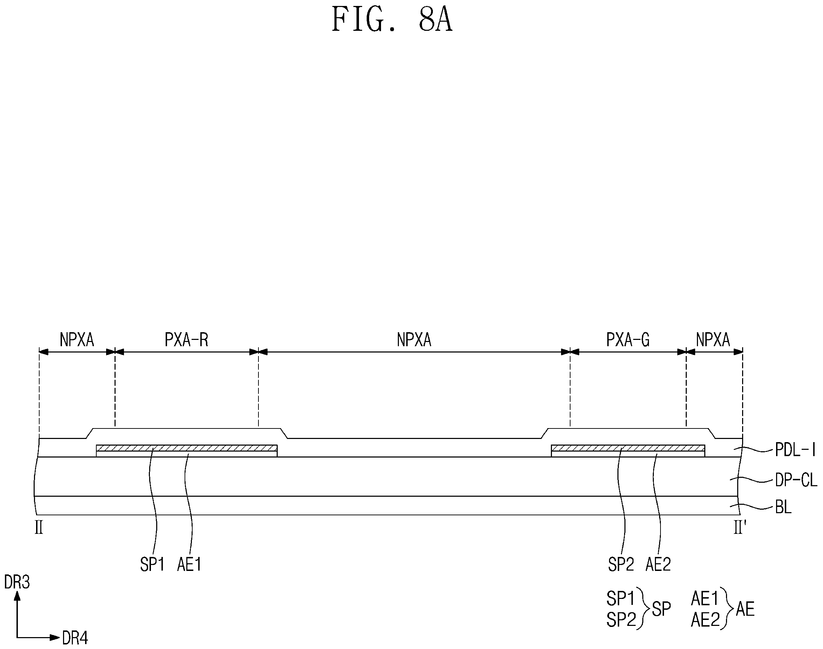

FIGS. 8A to 16B are cross-sectional views illustrating operations of the method for manufacturing a display panel DP (see FIG. 5) according to an embodiment of the invention.

FIGS. 8A to 16B exemplarily illustrate a cross-sectional view taken along line II-II' in FIG. 4 with respect to the operations of the method for manufacturing a display panel DP (see FIG. 5) according to the invention. Since a third light-emitting region PXA-B may be formed in the same operations as operations of the method for manufacturing first and second light-emitting regions PXA-R and PXA-G among the operations of the method for manufacturing to be described later, description for operations of the method for manufacturing the third light-emitting region PXA-B is omitted.

Referring to FIGS. 8A to 8C, the operation of preparing a preliminary display panel DP-I may include an operation of forming a circuit element layer DP-CL on a base layer BL, an operation of forming a first electrode AE, a sacrificial pattern SP, and a preliminary pixel-defining film PDL-I on the circuit element layer DP-CL, an operation of forming a first conductive layer PW1-I on the preliminary pixel-defining film PDL-I, and an operation of forming a second conductive layer PW2-I on the first conductive layer PW1-I.

FIG. 8A illustrates the operation of forming the circuit element layer DP-CL on the base layer BL, and the operation of forming the first electrode AE, the sacrificial pattern SP, and the preliminary pixel-defining film PDL-I on the circuit element layer DP-CL.

The circuit element layer DP-CL may be formed through a typical process, of manufacturing a circuit element, forming a semiconductor pattern, a conductive pattern, and a signal line by forming an insulating layer, a semiconductor layer, and a conductive layer in a manner such as coating or deposition, and selectively patterning the insulating layer, the semiconductor layer and the conductive layer by photolithography and etching processes.

The first electrode AE and the sacrificial pattern SP may be formed in the same patterning process. The preliminary pixel-defining film PDL-I may be formed so as to cover all of the first electrode AE and the sacrificial pattern SP.

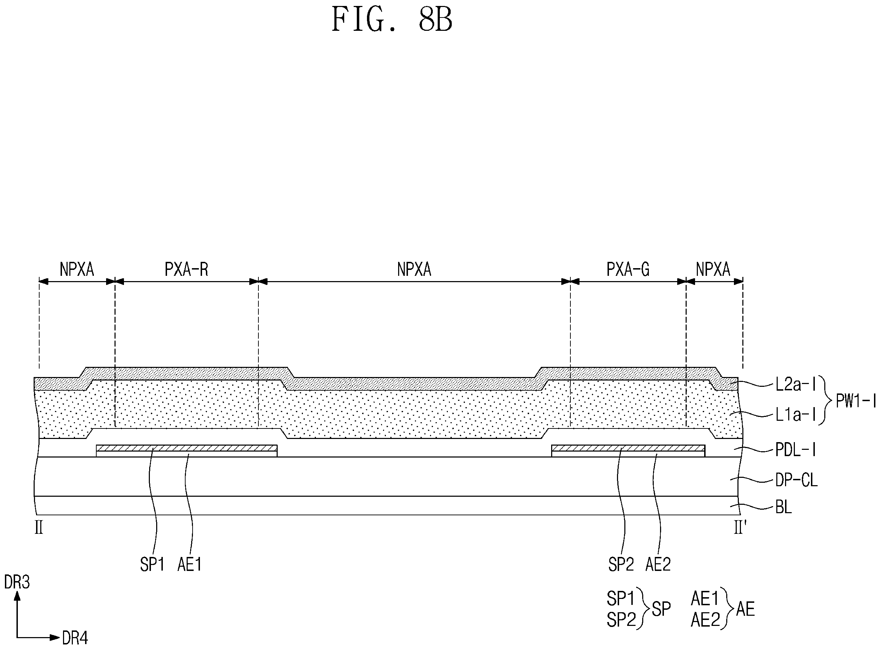

FIG. 8B illustrates the operation of forming the first conductive layer PW1-I on the preliminary pixel-defining film PDL-I.

The operation of forming the first conductive layer PW1-I may include an operation of forming a (1-1)-th conductive layer L1a-I on the preliminary pixel-defining film PDL-I, and an operation of forming a (1-2)-th conductive layer L2a-I on the (1-1)-th conductive layer L1a-I.

The operation of forming the (1-1)-th conductive layer L1a-I may be performed in a deposition process of a first conductive material. The first conductive material may include metal. In an embodiment, for example, the first conductive material may include aluminium (Al). In an embodiment, for example, the operation of forming the (1-1)-th conductive layer L1a-I may be performed in a sputtering process.

The operation of forming the (1-2)-th conductive layer L2a-I may be performed in a deposition process of a second conductive material. The second conductive material may include metal. In an embodiment, for example, the second conductive material may include titanium (Ti). In an embodiment, for example, the operation of forming the (1-2)-th conductive layer L2a-I may be performed in a sputtering process.

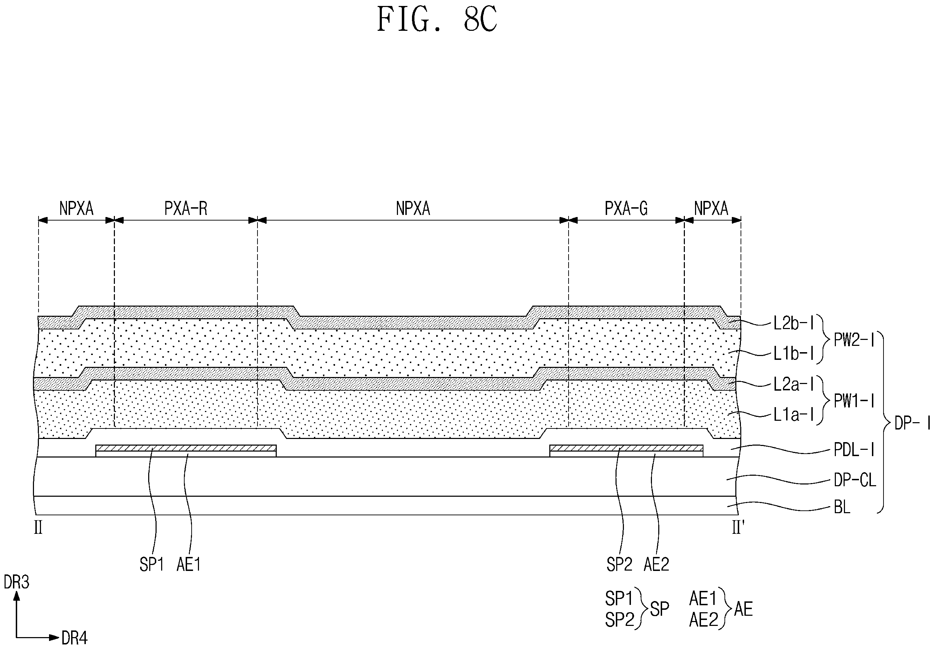

FIG. 8C illustrates the operation of forming the second conductive layer PW2-I on the first conductive layer PW1-I.

The operation of forming the second conductive layer PW2-I may include an operation of forming a (2-1)-th conductive layer L1b-I on the first conductive layer PW1-I, and an operation of forming a (2-2)-th conductive layer L2b-Ion the (2-1)-th conductive layer L1b-I.

The operation of forming the (2-1)-th conductive layer L1b-I may be performed in a deposition process of the first conductive material. The first conductive may include metal. In an embodiment, for example, the first conductive material may include aluminium (Al). In an embodiment, for example, the operation of forming the (2-1)-th conductive layer L1b-I may be performed in a sputtering process.

The operation of forming the (2-2)-th conductive layer L2b-I may be performed in a deposition process of the second conductive material. The second conductive material may include metal. In an embodiment, for example, the second conductive material may include titanium (Ti). In an embodiment, for example, the operation of forming the (2-2)-th conductive layer L2b-I may be performed in a sputtering process.

Referring to FIGS, 9A to 9C, the operation of patterning photoresist may include an operation of forming a first photoresist layer PR1 on the second conductive layer PW2-I, and an operation of exposing the first photoresist layer PR1.

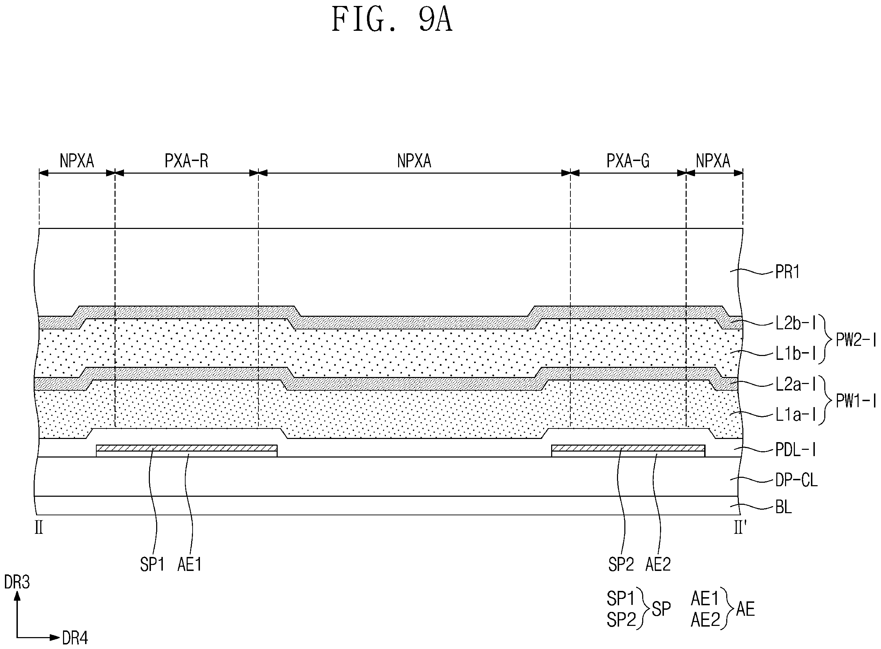

FIG. 9A illustrates the operation of forming the first photoresist layer PR1 on the second conductive layer PW2-I. The first photoresist layer PR1 may be formed by applying a photoresist material on the second conductive layer PW2-I.

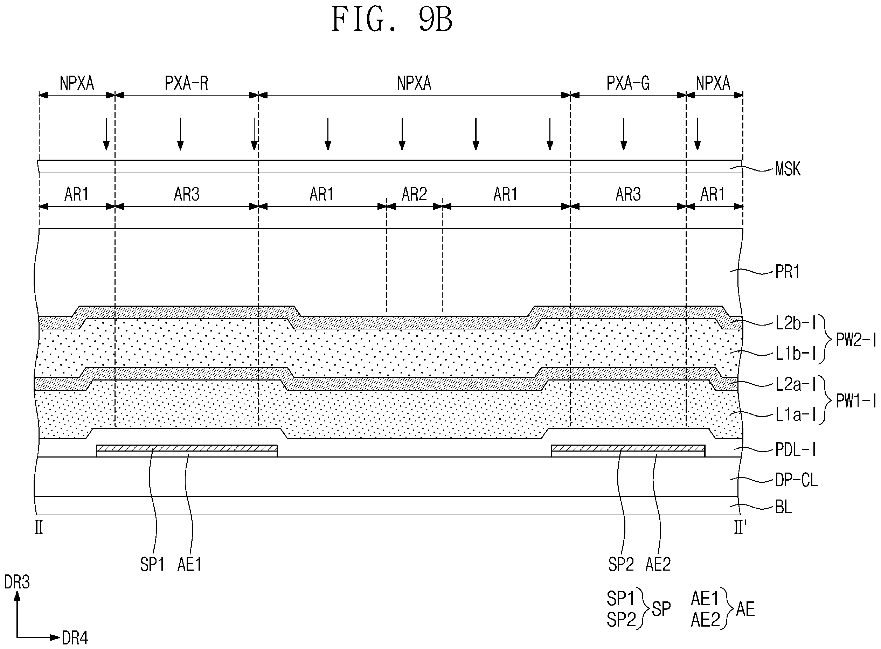

FIG. 9B illustrates an exposing process of patterning through a photo mask MSK. The photo mask MSK may be constituted so that portions corresponding to first to third regions AR1, AR2, and AR3 have different light-blocking characteristics, respectively.

In an embodiment, for example, the photo mask MSK may be constituted so that when a positive photoresist process is applied, a portion of the photo mask MSK corresponding to a first region AR1 is light-blocked, a portion of the photo mask MSK corresponding to a second region AR2 is semi-light-blocked, and a portion of the photo mask MSK corresponding to a third region AR3 is exposed.

Alternatively, reversely, the photo mask MSK may be constituted so that when a negative photoresist process is applied, the portion of the photo mask MSK corresponding to the first region AR1 is exposed, the portion of the photo mask MSK corresponding to the second region AR2 is semi-light-blocked, and the portion of the photo mask MSK corresponding to the third region AR3 is light-blocked.

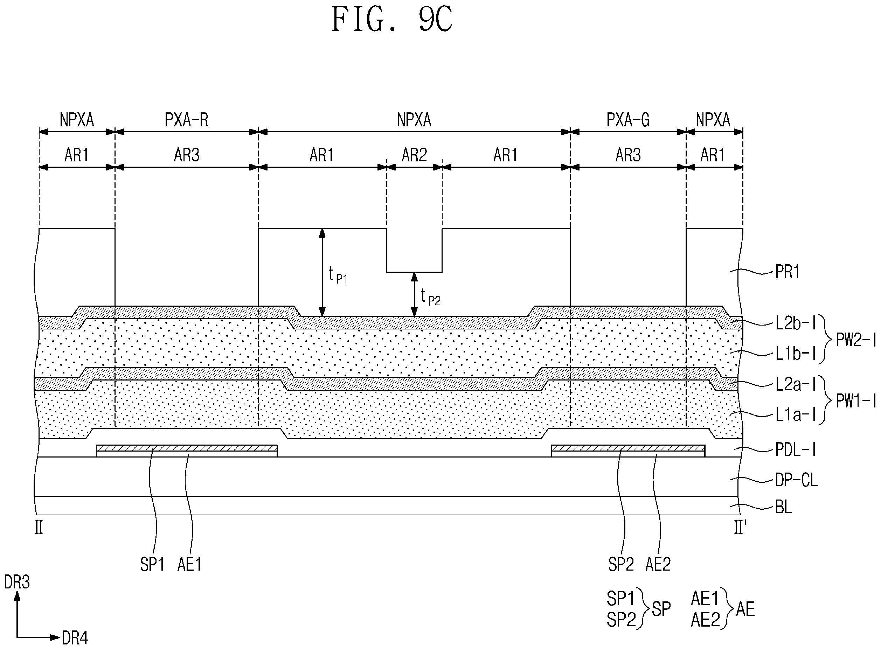

FIG. 9C illustrates that the first photoresist layer PR1 is patterned. The photoresist layer PR1 may be patterned to a first thickness t_{P1} in the first region AR1, the photoresist layer PR1 may be patterned to a second thickness t_{P2} smaller than the first thickness tP1 in the second region AR2, and the photoresist layer PR1 may be patterned so as not to be disposed in the third region AR3.

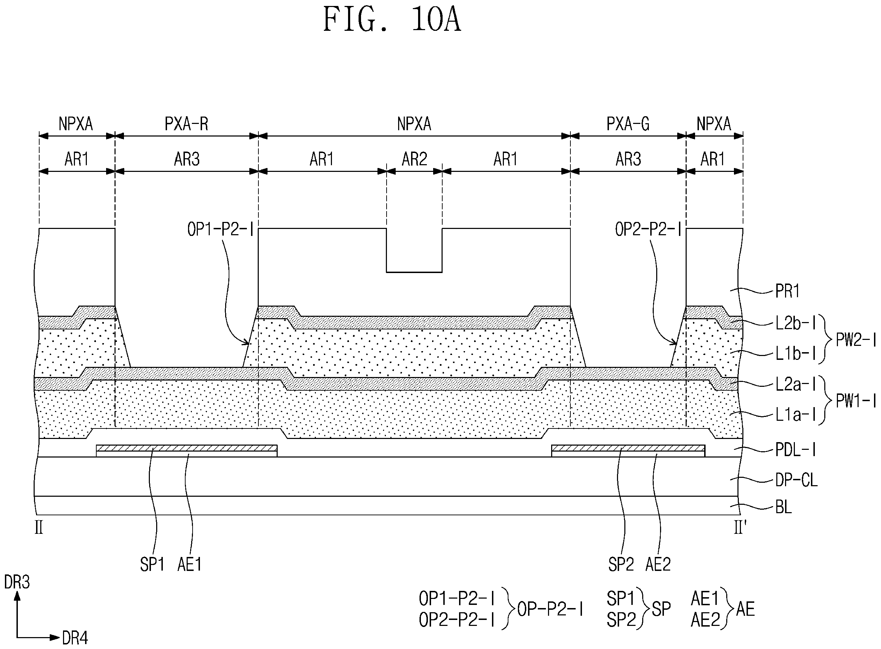

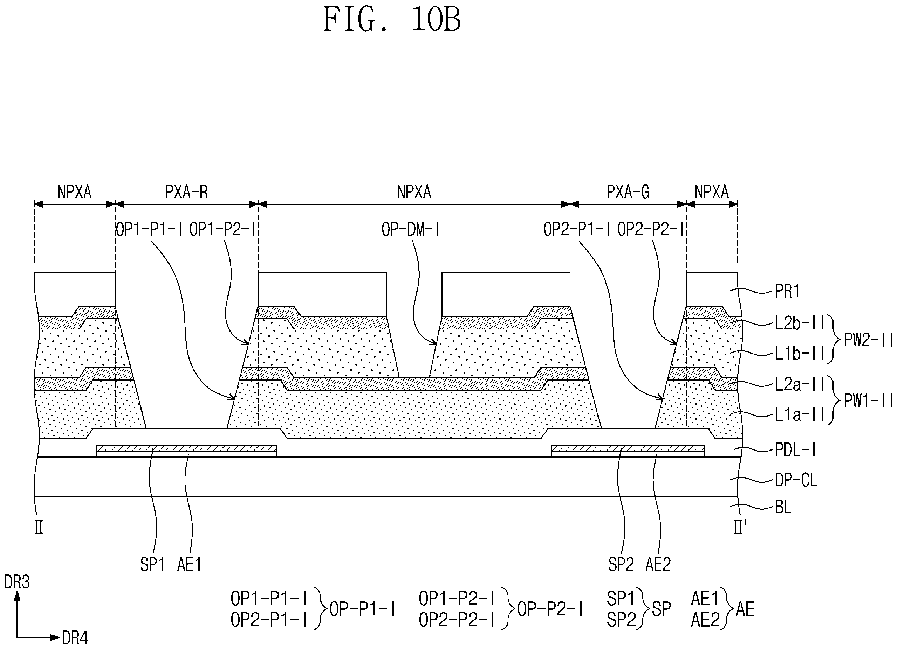

Referring to FIGS. 10A and 10B, the operation of forming a first preliminary conductive partition wall PW1-II and a second preliminary conductive partition wall PW2-II may include an operation of forming a second preliminary partition wall opening OP-P2-I in the second conductive layer PW2-I, and an operation of forming a first preliminary partition wall opening OP-P1-I in the first conductive layer PW1-I and forming a preliminary dummy opening OP-DM-I in the second conductive layer PW2-I.

FIG. 10A illustrates the operation of forming the second preliminary partition wall opening OP-P2-I. The second preliminary partition wall opening OP-P2-I may be formed in the second conductive layer PW2-I through a dry-etching process. Specifically, the second conductive layer PW2-I corresponding to the third region AR3 in which the photoresist layer PR1 is not disposed may be removed by a dry-etching process.

FIG. 10B illustrates the operation of forming the first preliminary conductive partition wall PW1-II and the second preliminary conductive partition wall PW2-II.

The operation of forming the first preliminary conductive partition wall PW1-II and the second preliminary conductive partition wall PW2-II may include an operation of ashing the photoresist layer PR1, and the operation of forming the first preliminary partition wall opening OP-P1-I in the first conductive layer PW1-I and forming the preliminary dummy opening OP-DM-I in the second conductive layer PW2-I.

The photoresist layer PR1 may be partially removed through an ashing process using oxygen plasma. Specifically, as illustrated in FIG. 10B, a thickness of the photoresist layer PR1 may totally decrease by the ashing process, so that the photoresist layer PR1 formed to a small thickness, and corresponding to the second region AR2 may be removed, and an upper surface of the second conductive layer PW2-I may be exposed.

Thereafter, the first preliminary partition wall opening OP-P1-I corresponding to the third region AR3 and the preliminary dummy opening OP-DM-I corresponding to the second region AR2 may be formed through a dry-etching process.

As illustrated in FIG. 10B, the first preliminary partition wall opening OP-P1-I may be defined in the first preliminary conductive partition wall PW1-II, and the second preliminary partition wall opening OP-P2-I and the preliminary dummy opening OP-DM-I may be defined in the second preliminary conductive partition wall PW2-II.

The first preliminary conductive partition wall PW1-II may include a first preliminary lower layer L1a-II formed from the (1-1)-th conductive layer L1a-I and a second preliminary lower layer L2a-II formed from the (1-2)-th conductive layer L2a-I. The second preliminary conductive partition wall PW2-II may include a first preliminary upper layer L1b-II formed from the (2-1)-th conductive layer L1b-I and a second preliminary upper layer L2b-II formed from the (2-2)-th conductive layer L2bI.

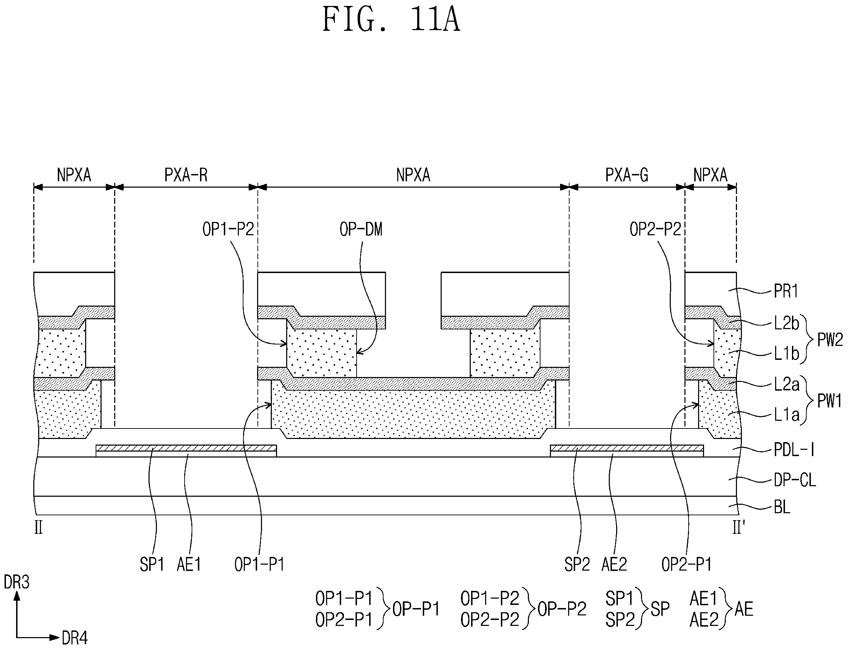

Referring to FIG. 11A, the operation of forming the first conductive partition wall PW1 and the second conductive partition wall PW2 may include an operation of forming a tip portion through a wet-etching process.

An etch rate of the first preliminary lower layer L1a-II may be greater than an etch rate of the second preliminary lower layer L2a-II, for an etching solution in the wet-etching process. Accordingly, as illustrated in FIG. 11A, the tip portion may be formed in the second lower layer L2a of the first conductive partition wall PW1. In addition, an etch rate of the first preliminary upper layer L1b-II may be greater than an etch rate of the second preliminary upper layer L2b-II, for the etching solution in the wet-etching process. Accordingly, as illustrated in FIG. 11A, the tip portion may be formed in the second upper layer L2b of the second conductive partition wall PW2.

The first conductive partition wall PW1 may include the first lower layer L1a formed from the first preliminary lower layer L1a-II and the second lower layer L2a formed from the second preliminary lower layer L2a-II. The second conductive partition wall PW2 may include the first upper layer L1b formed from the first preliminary upper layer L1b-II and the second upper layer L2b formed from the second preliminary upper layer L2b-II.

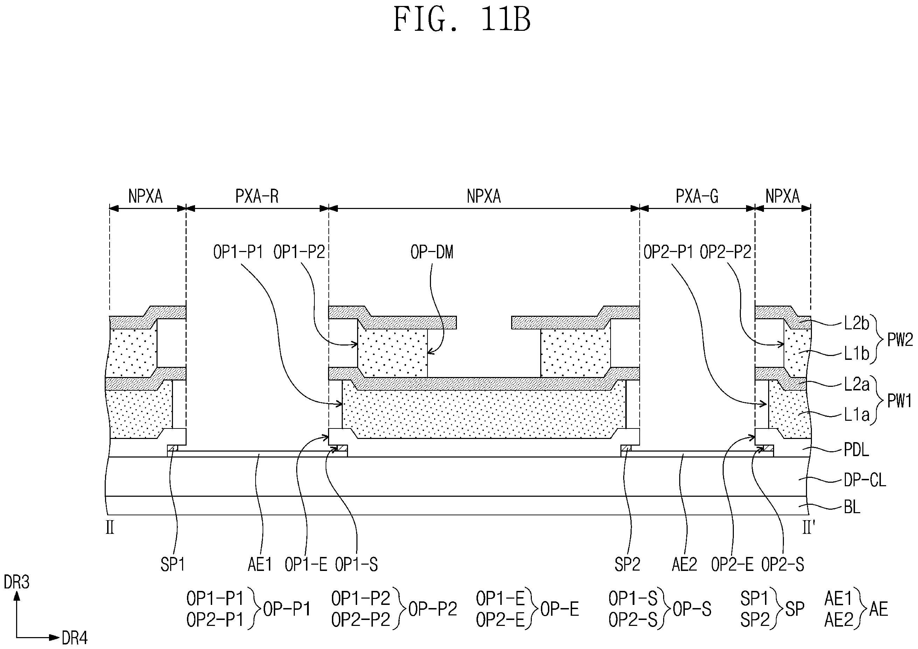

Referring to FIG. 11B, the method for manufacturing a display panel may include an operation of forming a light-emitting opening OP-E in the preliminary pixel-defining film PDL-I. In addition, the method for manufacturing a display panel according to an embodiment may further include an operation of forming a sacrificial opening OP-S. When the sacrificial pattern SP is not formed on the first electrode AE, the operation of forming the sacrificial opening OP-S may be omitted.

The light-emitting opening OP-E corresponding to the first partition wall opening OP-P1 and the second partition wall opening OP-P2 may be formed through a dry-etching process by etching the preliminary pixel-defining film PDL-I.

The sacrificial opening OP-S may be formed through a wet-etching process by etching the sacrificial pattern SP. The etching process of the sacrificial pattern SP may be performed by an etching solution in which an etch rate of the sacrificial pattern SP is greater than an etch rate of the first electrode AE. Accordingly, the first electrode AE may be prevented from being damaged in the etching process of the sacrificial pattern SP.

The first electrode AE may be partially exposed by the sacrificial opening OP-S and the light-emitting opening OP-E.

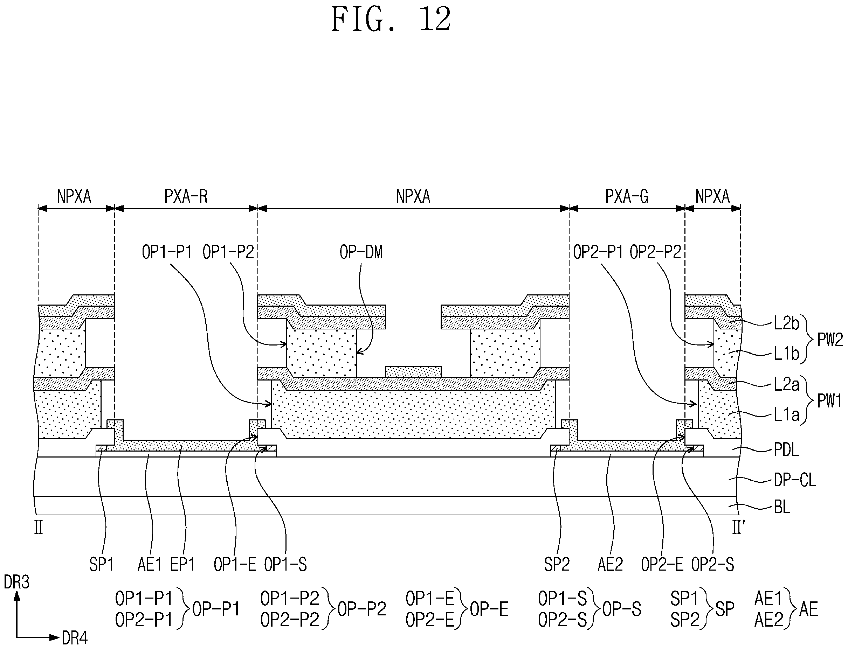

Referring to FIG. 12, the method for manufacturing a display panel may include the operation of forming the first light-emitting pattern EP1. In an embodiment, for example, the first light-emitting patterns EP1 may be formed through a thermal evaporation process. The first light-emitting pattern EP1 may be entirely formed, and may be removed except for the first light-emitting region PXA-R in the following operations.

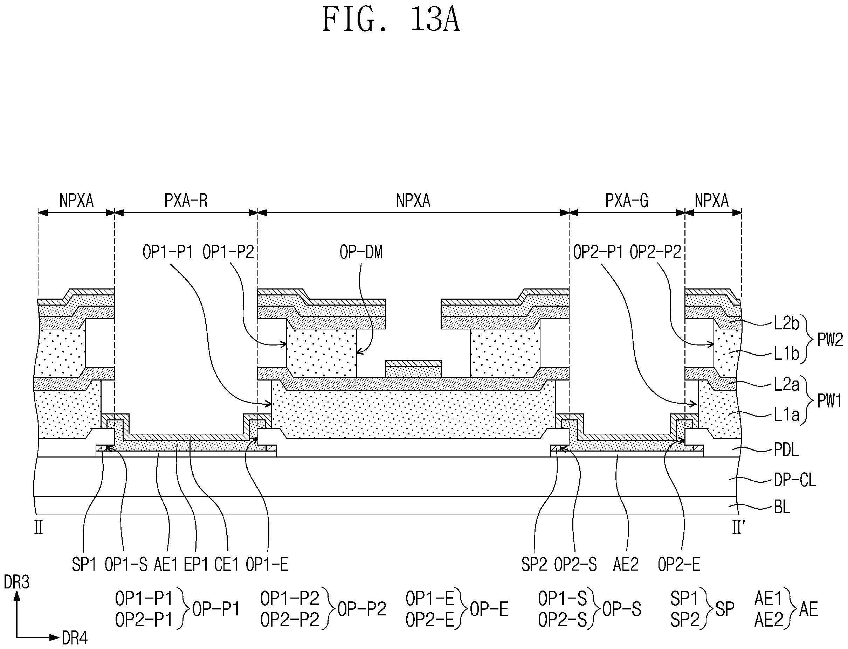

Referring to FIG. 13A, the method for manufacturing a display panel may include the operation of forming a second electrode CE1. In an embodiment, for example, the second electrode CE1 may be formed through a sputtering process. The second electrode CE1 may be entirely formed, and may be removed except the first light-emitting region PXA-R in the following operations.

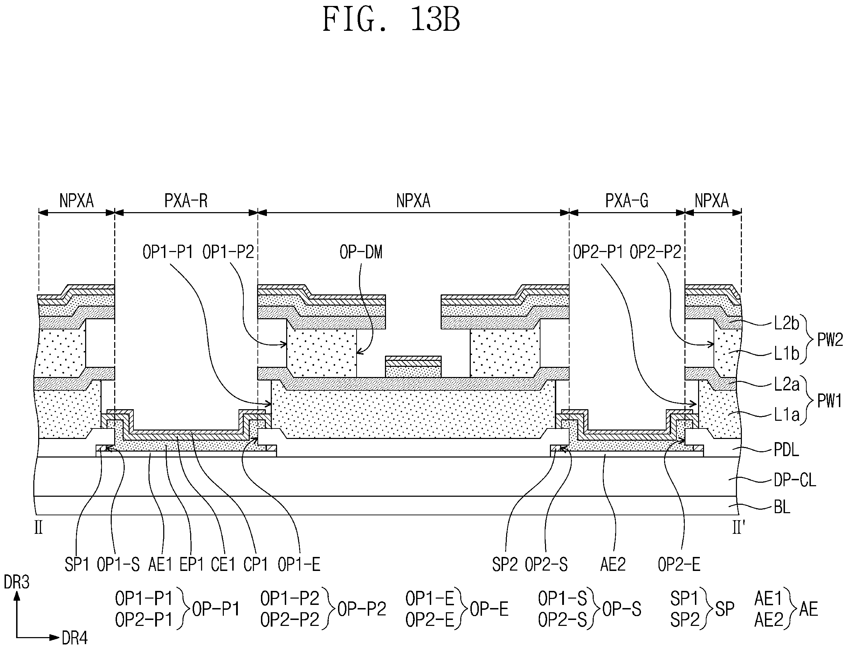

Referring to FIG. 13B, the method for manufacturing a display panel may further include an operation of forming a capping pattern CP1. In an embodiment, for example, the capping pattern CP1 may be formed through a thermal evaporation process. The capping pattern CP1 may be entirely formed, and may be removed except for the first light-emitting region PXA-R in the following operations. In an embodiment, the operation of forming the capping pattern CP1 may be omitted.

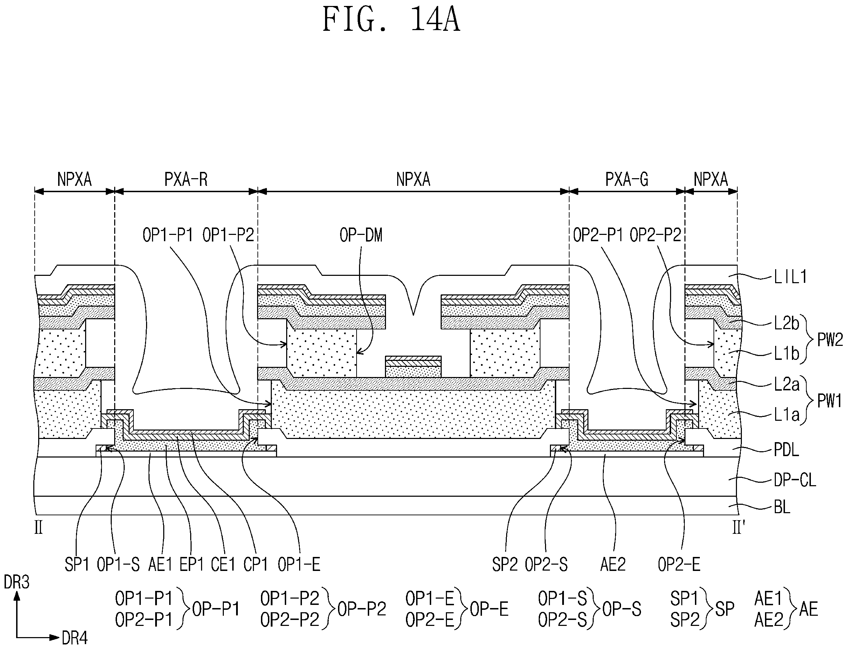

Referring to FIGS. 14A to 14C, an operation of forming a thin-film encapsulation layer TFE may include an operation of forming a first inorganic lower encapsulation pattern LIL1.

FIG. 14A illustrates the operation of entirely forming the first inorganic lower encapsulation pattern LIL1. The first inorganic lower encapsulation pattern LIL1 may include an inorganic material. In an embodiment, for example, the first inorganic lower encapsulation pattern LIL1 may include silicon nitride (SiNₓ). The first inorganic lower encapsulation pattern LIL1 may be formed through, for example, a chemical vapor deposition (CVD) process.

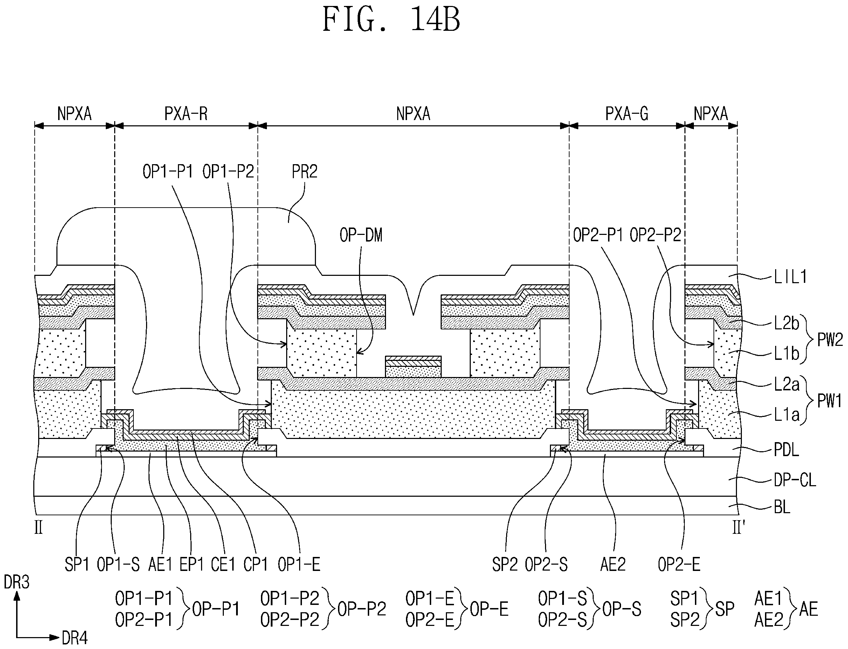

FIG. 14B illustrates an operation of forming a second photoresist layer PR2. The second photoresist layer PR2 may be patterned in a form of overlapping a region corresponding to the first light-emitting region PXA-R in the plan view.

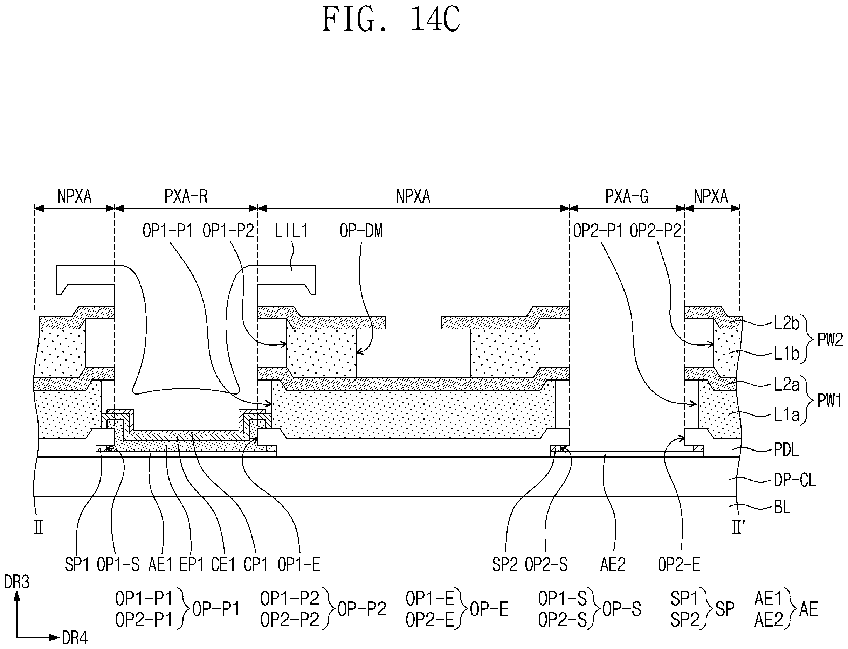

FIG. 14C illustrates that the first inorganic lower encapsulation pattern LIL1, the capping pattern CP1, the second electrode CE1, and the first light-emitting pattern EP1 formed in a region except for the second photoresist layer PR2 are removed through dry-etching, wet-etching, and stripping.

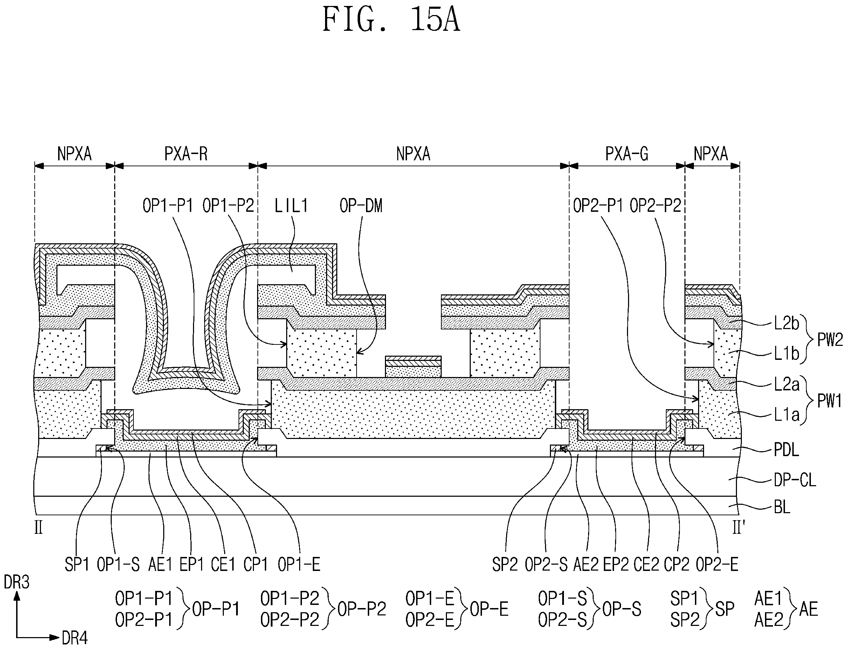

FIGS. 15A to 15D illustrate an operation of patterning the second light-emitting region PXA-G.

FIG. 15A illustrates an operation of forming a second light-emitting pattern EP2, a second electrode CE2, and a capping pattern CP2. In an embodiment, for example, the second light-emitting pattern EP2 may be formed by a thermal evaporation process. The second electrode CE2 may be formed through a sputtering process, and the capping pattern CP2 may be formed by a thermal evaporation process.

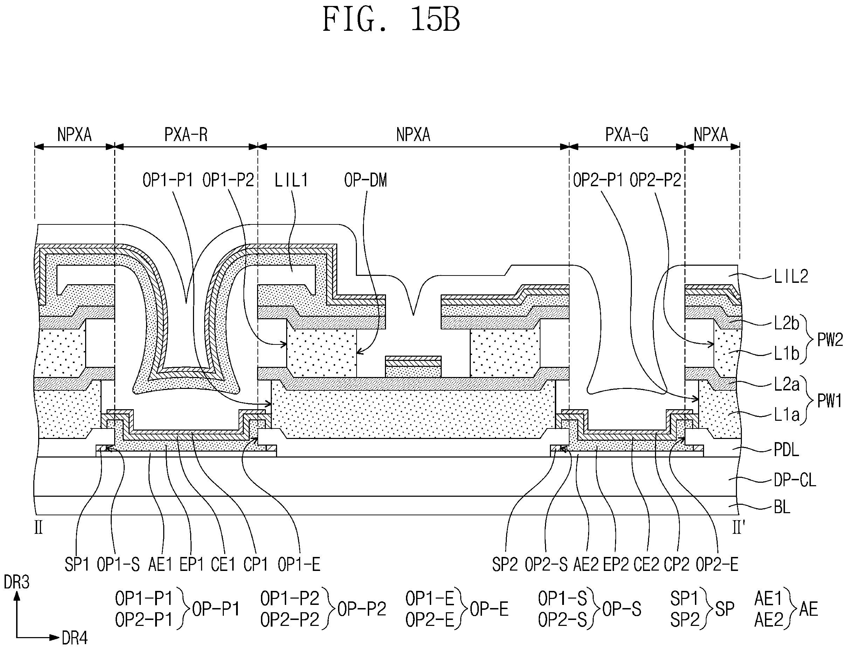

FIG. 15B illustrates an operation of entirely forming a second inorganic lower encapsulation pattern LIL2. The second inorganic lower encapsulation pattern LIL2 may include an inorganic material, for example, silicon nitride. The second inorganic lower encapsulation pattern LIL2 may be formed through, for example, a chemical vapor deposition (CVD) process.

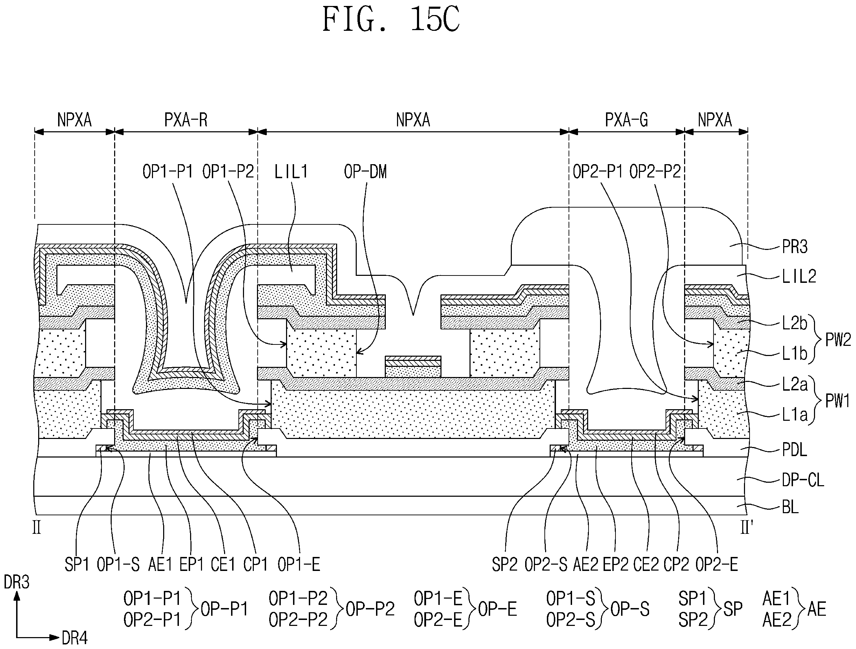

FIG. 15C illustrates an operation of forming a third photoresist layer PR3. The third photoresist layer PR3 may be patterned in a form of overlapping a region corresponding to the second light-emitting region PXA-G in a plan view.

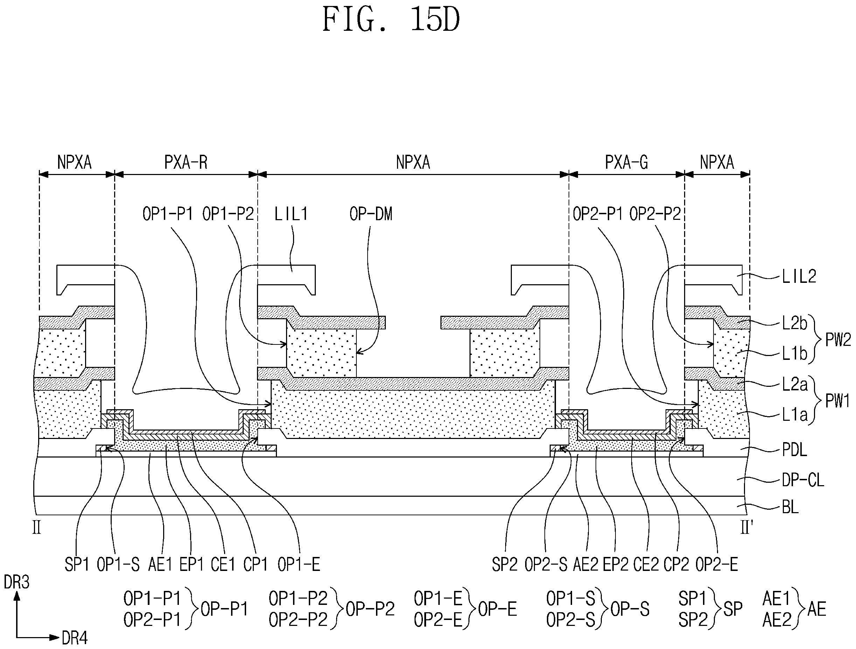

FIG. 15D illustrates that the second inorganic lower encapsulation pattern LIL2, the capping pattern CP2, the second electrode CE2, and the second light-emitting pattern EP2 formed in a region except for the third photoresist layer PR3 are removed through dry-etching, wet-etching, and stripping.

After the first light-emitting region PXA-R and the second light-emitting region PXA-G are patterned, the third light-emitting region PXA-B may be patterned in the same method.

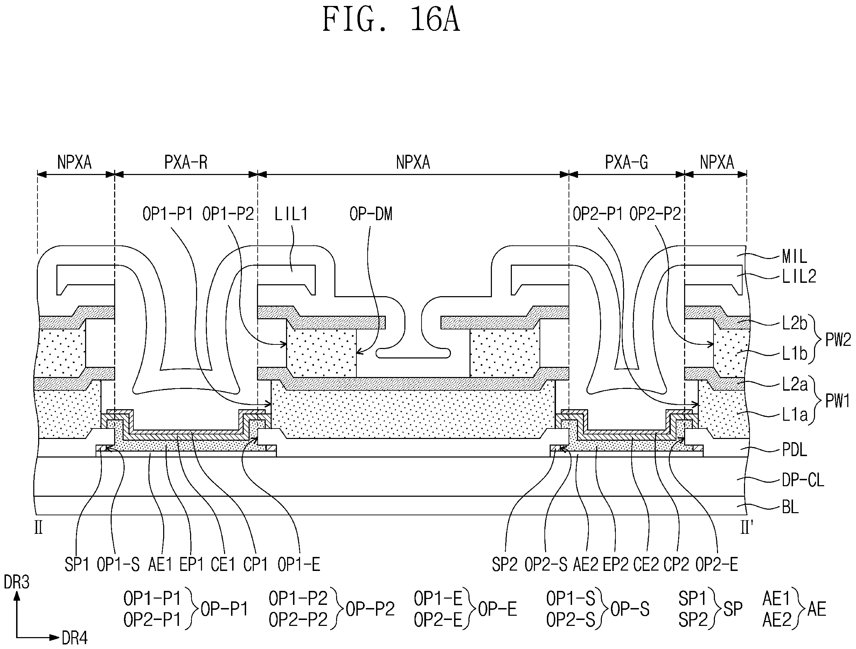

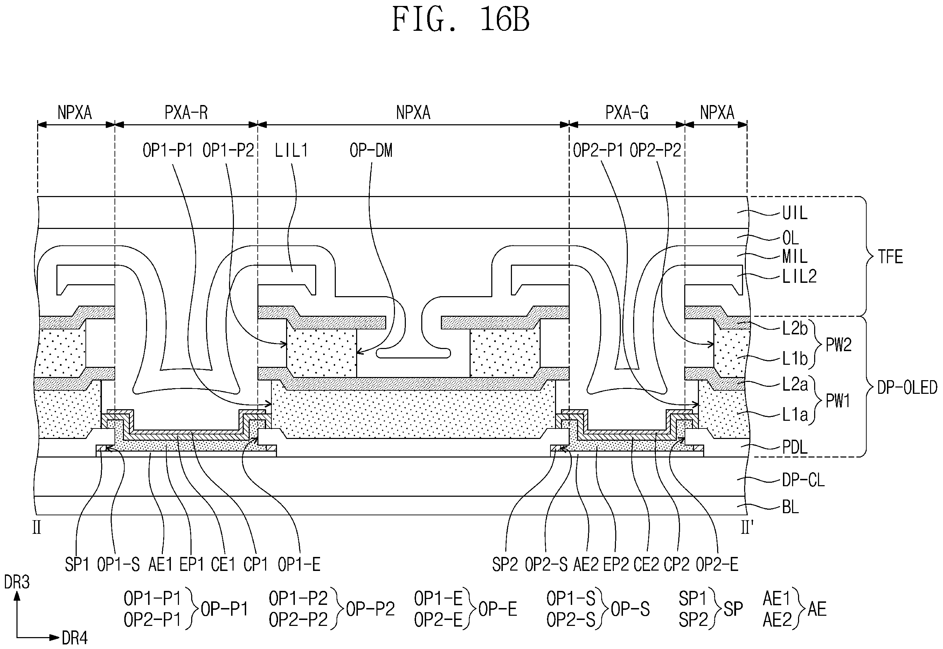

Referring to FIGS. 16A and 16B, the operation of forming the thin-film encapsulation layer TFE may include an operation of forming an inorganic intermediate encapsulation film MIL, an operation of forming an organic encapsulation film OL, and an operation of forming an inorganic upper encapsulation film UIL.

FIG. 16A illustrates the operation of forming the inorganic intermediate encapsulation film MIL. The inorganic intermediate encapsulation film MIL may include an inorganic material. In an embodiment, for example, the inorganic intermediate encapsulation film MIL my include silicon nitride. The inorganic intermediate encapsulation film MIL may be entirely formed. Accordingly, contact areas of the first and second conductive partition walls PW1 and PW2 and the inorganic films LIL and MIL may increase.

FIG. 16B illustrates the operation of forming the organic encapsulation film OL and the inorganic upper encapsulation film UIL on the inorganic intermediate encapsulation film MIL. The opening OP may be formed by, for example, applying an organic material in an ink-jet process. The organic encapsulation film OL may supply a flat upper surface. The inorganic upper encapsulation film UIL may be formed by, for example, depositing an inorganic material.

As described above in FIGS. 9A to 10B, the method for manufacturing a display panel according to the invention may form the photoresist layer PR1 so as to respectively have thicknesses different according to regions by respectively controlling exposure degrees according to the regions in a photoresist process accompanying the operation of forming the conductive partition walls PW1 and PW2. Accordingly, the dummy opening OP-DM may be formed without an additional photoresist process. In addition, without an additional photoresist process, a number, a position and/or a shape of the dummy opening OP-DM may be controlled by controlling the regions in the photoresist process. That is, without an additional photoresist process, a display panel having a structure capable of increasing contact areas between the conductive partition walls PW1 and PW2 and an inorganic film for blocking moisture may be manufactured.

According to what is described above, a display panel according to the invention has a structure in which a contact area between an inorganic encapsulation film and a conductive partition wall increases, thereby preventing infiltration of moisture, and improving reliability of the display panel.

In addition, a method for manufacturing a display panel according to the invention may form the structure in which the contact area between the inorganic encapsulation film and the conductive partition wall increases without an additional photomask, thereby having excellent processability.

In the above, description has been made with reference to preferred embodiments of the invention, but those skilled in the art or those of ordinary skill in the relevant technical field may understand that various modifications and changes may be made to the invention within the scope not departing from the technology scope of the invention described in the claims to be described later. Therefore, the technical scope of the invention is not limited to the contents described in the detailed description of the specification, but should be determined by the claims.

## Claims

1. A display panel comprising:
a base layer;
a first electrode disposed on the base layer;
a pixel-defining film in which a light-emitting opening partially exposing the first electrode is defined, and which is disposed on the base layer;
a first conductive partition wall in which a first partition wall opening overlapping the light-emitting opening in a plan view is defined, and which is disposed on the pixel-defining film;
a second conductive partition wall in which a second partition wall opening overlapping the first partition wall opening, and a dummy opening overlapping the first conductive partition wall in the plan view are defined, and which is disposed on the first conductive partition wall;
a second electrode disposed on the first electrode; and
a light-emitting pattern disposed between the first electrode and the second electrode.

2. The display panel of claim 1, further comprising an inorganic lower encapsulation pattern disposed on the second electrode, and configured to cover the light-emitting opening, the first partition wall opening, and the second partition wall opening.

3. The display panel of claim 2, further comprising an inorganic intermediate encapsulation film configured to cover the dummy opening and an upper surface of the second conductive partition wall.

4. The display panel of claim 3, wherein an upper surface of the first conductive partition wall exposed by the dummy opening is in contact with the inorganic intermediate encapsulation film.

5. The display panel of claim 3 or claim 4, wherein a side surface defining the second partition wall opening of the second conductive partition wall is in contact with the inorganic lower encapsulation pattern, and
a side surface defining the dummy opening of the second conductive partition wall is in contact with the inorganic intermediate encapsulation film.

6. The display panel of any one of claims 1 to 5, wherein the dummy opening is provided in plurality.

7. The display panel of any one of claims 1 to 6, wherein the first conductive partition wall comprises a first lower layer disposed on the pixel-defining film and a second lower layer disposed on the first lower layer, and
a side surface of the second lower layer protrudes further than a side surface of the first lower layer in the plan view.

8. The display panel of any one of claims 1 to 7, wherein the second conductive partition wall comprises a first upper layer disposed on the first conductive partition wall and a second upper layer disposed on the first upper layer, and
a side surface of the second upper layer protrudes further than a side surface of the first upper layer in the plan view.

9. The display panel of any one of claims 1 to 8, wherein the second electrode is in contact with a side surface of the first conductive partition wall to be electrically connected to each other.

10. The display panel of any one of claims 1 to 9, wherein the first conductive partition wall is configured to receive a bias voltage.

11. The display panel of claim 2, further comprising an inorganic dummy encapsulation film configured to cover the dummy opening.

12. The display panel of claim 11, further comprising a dummy pattern disposed on the first conductive partition wall in the dummy opening.

13. The display panel of claim 12, wherein the dummy pattern is not in contact with the second conductive partition wall.

14. The display panel of any one of claims 11 to 13, wherein a side surface defining the second partition wall opening of the second conductive partition wall is in contact with the inorganic lower encapsulation pattern, and
a side surface defining the dummy opening of the second conductive partition wall is in contact with the inorganic dummy encapsulation film.

15. A method for manufacturing a display panel, the method comprising:
preparing a preliminary display panel including a base layer, a first conductive electrode disposed on the base layer, a preliminary pixel-defining film configured to cover the first electrode and disposed on the base layer, a first conductive layer disposed on the preliminary pixel-defining film, and a second conductive layer disposed on the first conductive layer;
patterning photoresist on the preliminary display panel;
forming a second preliminary partition wall opening in the second conductive layer;
forming a first preliminary conductive partition wall by forming, in the first conductive layer, a first preliminary partition wall opening overlapping the second preliminary partition wall opening in a plan view;
forming a second preliminary conductive partition wall by forming, in the second conductive layer, a preliminary dummy opening spaced apart from the second preliminary partition wall opening;
forming a light-emitting pattern on the first electrode; and
forming a second electrode on the light-emitting pattern,
wherein in the patterning of the photoresist,
the photoresist is patterned to have a first thickness in a first region overlapping neither the second preliminary partition wall opening nor the preliminary dummy opening in the plan view,
the photoresist is patterned to have a second thickness smaller than the first thickness in a second region overlapping the preliminary dummy opening in the plan view, and
the photoresist is patterned not to be disposed in a third region overlapping the second preliminary partition wall opening in the plan view.
